# EUROPEAN PATENT APPLICATION

(11) **EP 4 351 296 A2**
(43) Date of publication of application: **10.04.2024**
(21) Application number: 23193964.6
(22) Date of filing: 29.08.2023
(51) Int. Cl.: H10B 41/10, H10B 41/27, H10B 43/10, H10B 43/27

(54) **SEMICONDUCTOR DEVICES**

(30) Priority: 05.10.2022 KR 20220126700
(71) Applicant: Samsung Electronics Co., Ltd., Suwon-si, Gyeonggi-do 16677 (KR)
(72) Inventor: HAN, Myunghoon, Suwon-si, Gyeonggi-do 16677 (KR); JANG, Sehee, Suwon-si, Gyeonggi-do 16677 (KR); KIM, Hyunho, Suwon-si, Gyeonggi-do 16677 (KR); HAN, Jeehoon, Suwon-si, Gyeonggi-do 16677 (KR)
(74) Representative: Kuhnen & Wacker Patent- und Rechtsanwaltsbüro PartG mbB

(57) **Abstract**

A semiconductor device includes a gate electrode structure, a memory channel structure, a first division pattern, and first support patterns. The gate electrode structure includes gate electrodes spaced apart from each other on a substrate in a first direction perpendicular to an upper surface of the substrate, and each of the gate electrodes extends in a second direction parallel to the upper surface of the substrate. The memory channel structure extends through the gate electrode structure on the substrate. The first division pattern is formed on a sidewall of the gate electrode structure in a third direction parallel to the upper surface of the substrate and crossing the second direction, and extends in the second direction. The first support patterns are spaced apart from each other in the second direction on the first division pattern, and each of the first support patterns includes a conductive material.

## Description

### CROSS-REFERENCE TO RELATED APPLICATIONS

This application claims priority to Korean Patent Application No. 10-2022-0126700, filed on October 5, 2022 in the Korean Intellectual Property Office (KIPO), the contents of which are herein incorporated by reference in their entirety.

### TECHNICAL FIELD

The inventive concepts relate to a semiconductor device. More particularly, the inventive concepts relate to a vertical memory device.

### DISCUSSION OF RELATED ART

In electronic systems having data storage, a high capacity semiconductor device that may store high capacity data is desirable. Thus, a method of increasing the data storage capacity of the semiconductor device has been studied. For example, a semiconductor device including memory cells that may be 3-dimensionally stacked has been suggested.

As the number of memory cells stacked in the vertical direction increases, a mold for forming the memory cells may be bent or collapsed, and thus a method of preventing the mold from being bent has been studied.

### SUMMARY

Example embodiments provide a semiconductor device having improved characteristics.

According to an aspect of the inventive concept, a semiconductor device includes a gate electrode structure including a plurality of gate electrodes spaced apart from each other on a substrate in a first direction substantially perpendicular to an upper surface of the substrate, each of the plurality of gate electrodes extending in a second direction substantially parallel to the upper surface of the substrate, a memory channel structure extending through the gate electrode structure, a plurality of first division patterns spaced apart from each other in a third direction substantially parallel to the upper surface of the substrate and crossing the second direction, the gate electrode structure being interposed between two adjacent first division patterns among the plurality of first division patterns, and each of the plurality of first division patterns extending in the second direction, and a plurality of first support patterns spaced apart from each other in the second direction. The plurality of first support patterns are arranged along a first straight line extending in the second direction. A corresponding first division pattern of the plurality of first division patterns extends along the first straight line such that the corresponding first division pattern and the plurality of first support patterns are arranged along the first straight line. Each of the plurality of first support patterns includes a conductive material.

According to an aspect of the inventive concept, a semiconductor device includes a gate electrode structure including a plurality of gate electrodes spaced apart from each other on a substrate in a first direction substantially perpendicular to an upper surface of the substrate, each of the plurality of gate electrodes extending in a second direction substantially parallel to the upper surface of the substrate, a memory channel structure extending through the gate electrode structure on the substrate, a plurality of first division patterns spaced apart from each other in a third direction substantially parallel to the upper surface of the substrate and crossing the second direction, the gate electrode structure being interposed between two adjacent first division patterns among the plurality of first division patterns, and each of the plurality of first division patterns extending in the second direction, and a plurality of first support patterns spaced apart from each other in the second direction.

According to an aspect of the inventive concept, a semiconductor device includes a lower circuit pattern on a substrate, a common source plate (CSP) on the lower circuit pattern, a gate electrode structure disposed on the CSP, wherein the gate electrode structure includes a first gate electrode, at least one second gate electrode, and a third gate electrode that are spaced apart from each other in a first direction substantially perpendicular to an upper surface of the substrate, and wherein each of the first gate electrode, the at least one second gate electrode, and the third gate electrode extends in a second direction substantially parallel to the upper surface of the substrate, a memory channel structure extending through the gate electrode structure on the CSP, a pair of first division patterns extending in the second direction along opposite sidewalls of the gate electrode structure, respectively, wherein the pair of first division patterns are spaced apart from each other in a third direction being substantially parallel to the upper surface of the substrate and crossing the second direction, a plurality of first support patterns spaced apart from each other in the second direction, wherein the plurality of first support patterns are arranged along a first straight line extending in the second direction, wherein a corresponding first division pattern of the pair of first division patterns extends along the first straight line, and wherein each of the plurality of first support patterns includes a conductive material, a second division pattern extending in the second direction partially through the gate electrode structure between the first division patterns, a plurality of second support patterns spaced apart from each other in the second direction, wherein the second division pattern and the plurality of second support patterns are arranged in a second straight line extending in the second direction, and wherein each of the plurality of second support patterns includes a conductive material, and a first contact plug, at least one second contact plug, and a third contact plug that contact upper surfaces of the first gate electrode, the at least one second electrode, and the third gate electrode, respectively. Each of the plurality of first and second support patterns is disposed at a level substantially the same as a level of the third gate electrode, and includes a conductive material substantially the same as a material of the third gate electrode.

In the method of manufacturing a semiconductor device in accordance with example embodiments, the support layer may be formed on the mold in order to prevent the mold from collapsing, and the support layer may include a conductive material so as to serve as a gate electrode. Thus, the fabrication of the semiconductor device may be simplified.

### BRIEF DESCRIPTION OF THE DRAWINGS

FIGS. 1 to 6 are plan views and cross-sectional views illustrating a semiconductor device.
FIGS. 7 to 43 are plan views and cross-sectional views illustrating a method of manufacturing a semiconductor device.
FIGS. 44 and 45 are a plan view and a cross-sectional view, respectively, illustrating a semiconductor device in accordance with example embodiments.
FIGS. 46A and 46B are cross-sectional views illustrating semiconductor devices in accordance with example embodiments.
FIG. 47 is across-sectional views illustrating a semiconductor device in accordance with example embodiments.
FIG. 48 is a cross-sectional view illustrating a semiconductor device in accordance with example embodiments.
FIG. 49 is a cross-sectional view illustrating a semiconductor device in accordance with example embodiments.
FIG. 50 is a schematic diagram illustrating an electronic system including a semiconductor device in accordance with example embodiments.
FIG. 51 is a schematic perspective view illustrating an electronic system including a semiconductor device in accordance with example embodiments.
FIGS. 52 and 53 are schematic cross-sectional views illustrating a semiconductor package that may include a semiconductor device in accordance with example embodiments.

### DETAILED DESCRIPTION

Hereinafter, a semiconductor device, a method for manufacturing the same, and a mass data storage system including the semiconductor device in accordance with example embodiments will be described in detail with reference to the accompanying drawings. It will be understood that, although the terms "first," "second," and/or "third" may be used herein to describe various elements, these elements should not be limited by these terms. These terms are only used to distinguish one element from another element.

In the specification (and not necessarily in the claims), a vertical direction substantially perpendicular to an upper surface of a substrate may be referred to as a first direction D1, and two directions crossing each other among horizontal directions substantially parallel to the upper surface of the substrate may be referred to as second and third directions D2 and D3, respectively. In example embodiments, the second and third directions may be substantially perpendicular to each other.

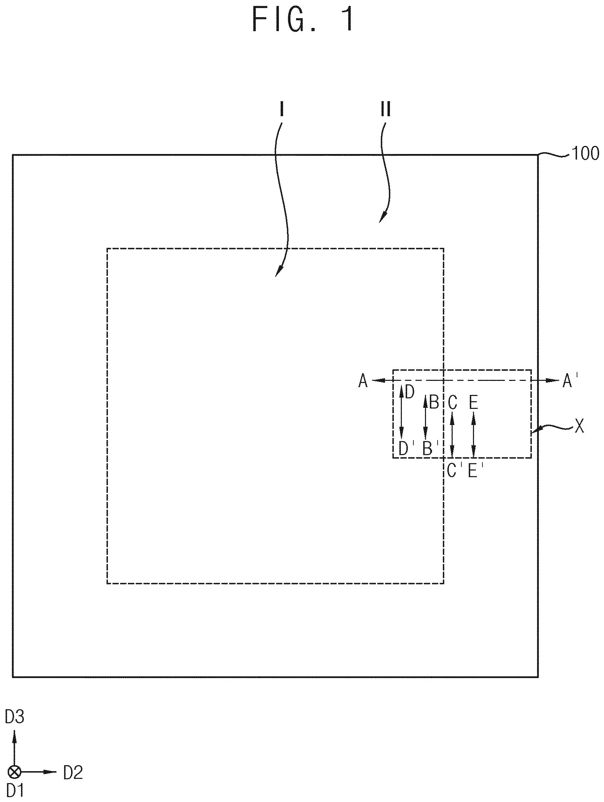

FIGS. 1 to 6 are plan views and cross-sectional views illustrating a semiconductor device, for example, a vertical channel NAND flash memory device in accordance with example embodiments.

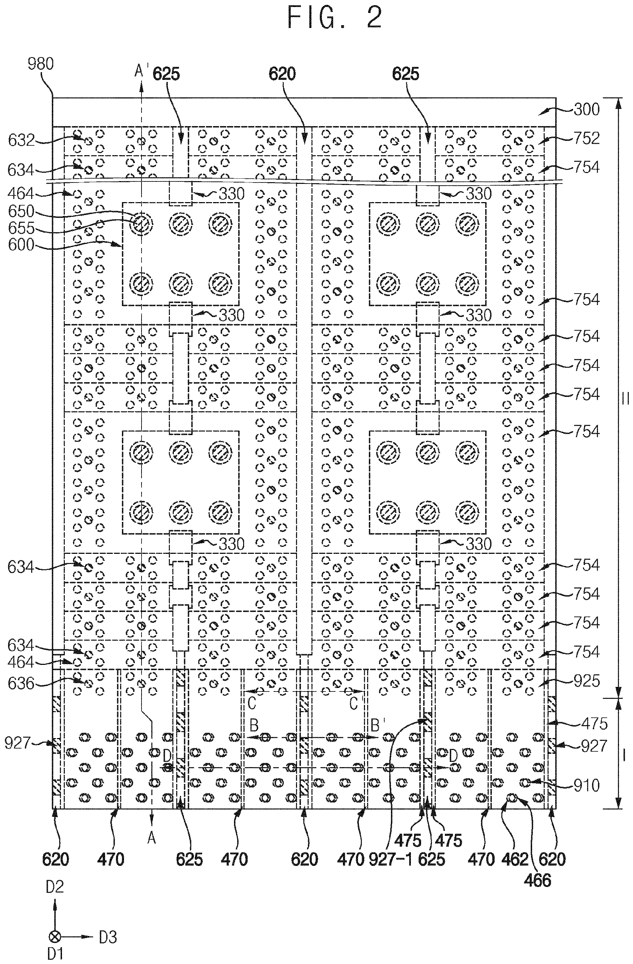

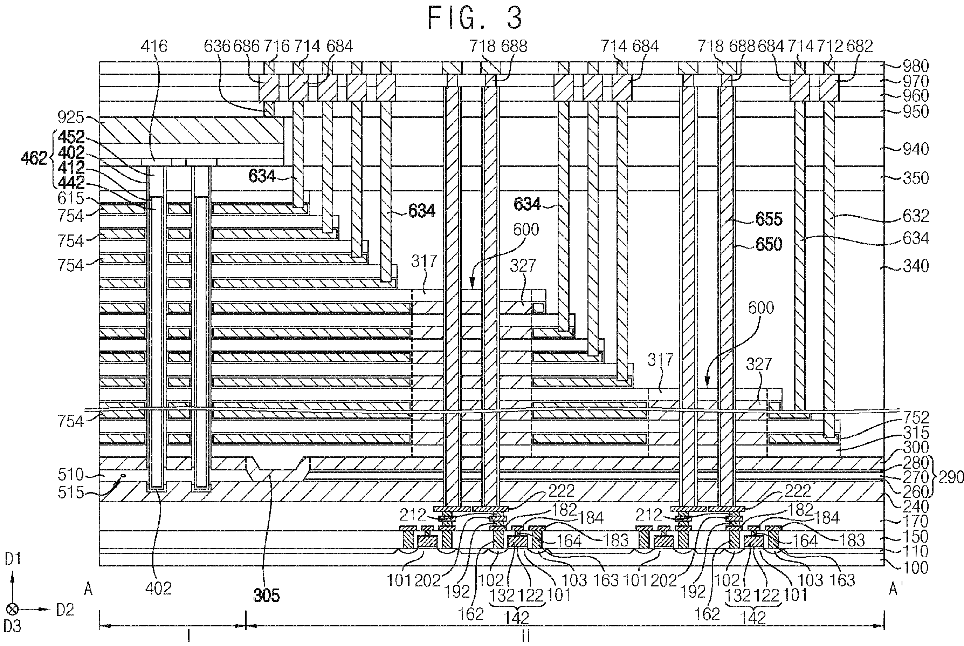

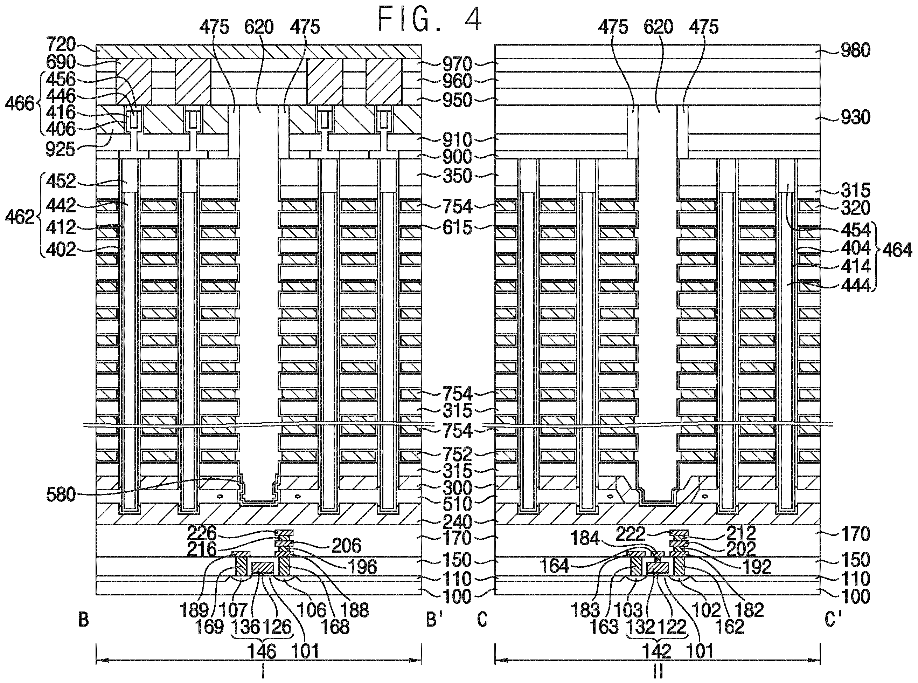

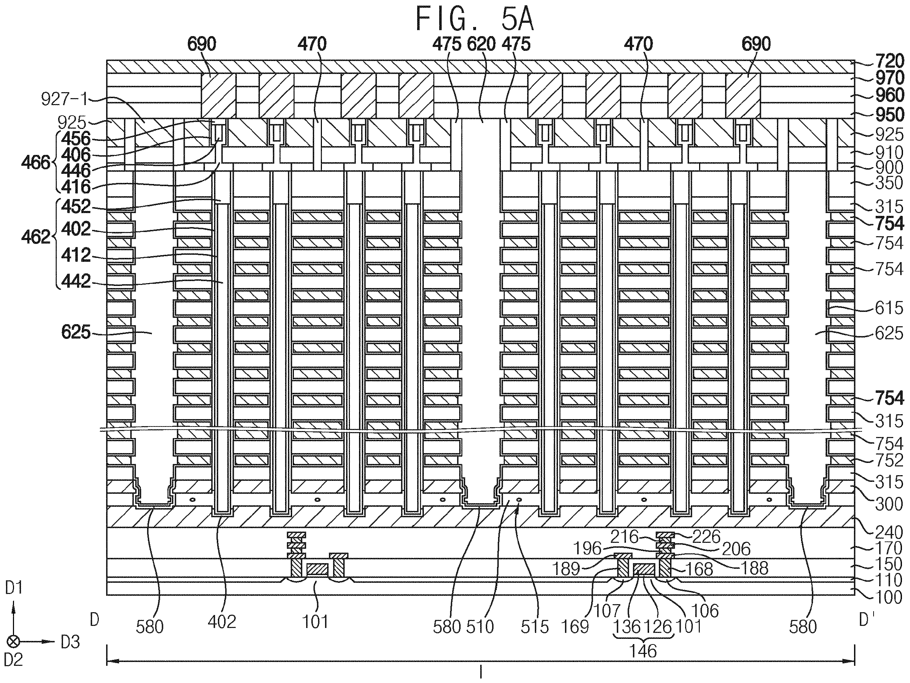

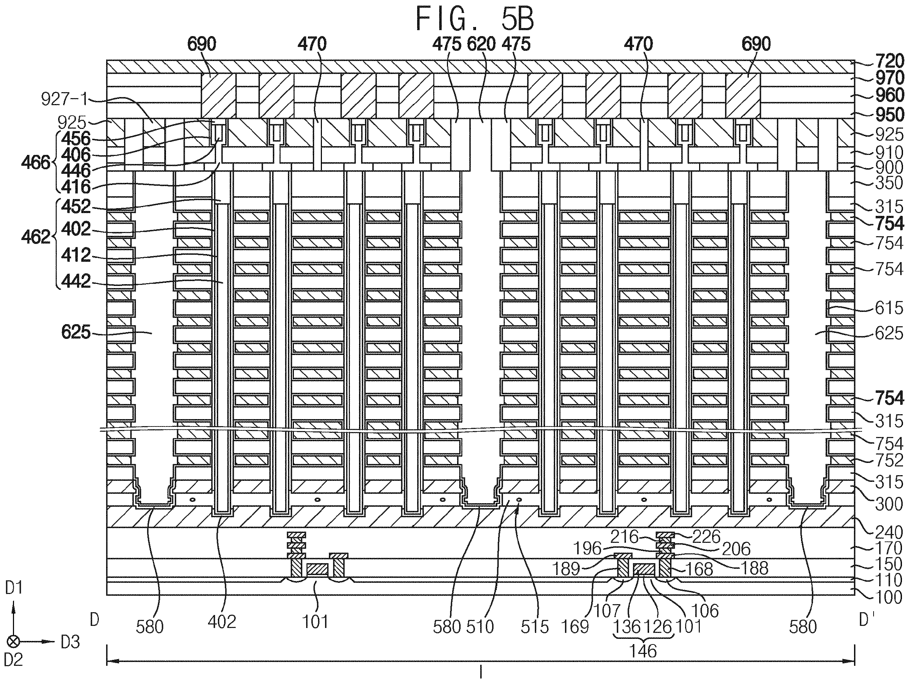

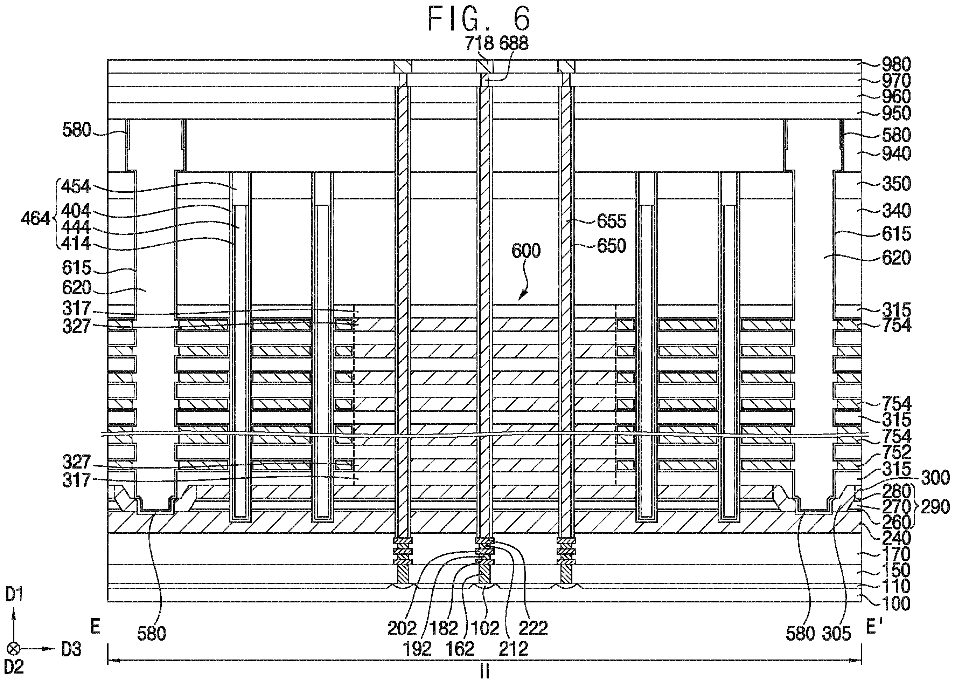

Particularly, FIGS. 1 and 3 are the plan views, FIG. 3 is a cross-sectional view taken along line A-A' of FIG. 2, FIG. 4 includes cross-sectional views taken along lines B-B' and C-C' of FIG. 2, FIG. 5 is a cross-sectional view taken along line D-D' of FIG. 2, and FIG. 6 is a cross-sectional view taken along line E-E' of FIG. 2. FIGS. 2 to 6 show region X in FIG. 1.

FIG. 2 does not show some elements, e.g., upper wirings and upper contact plugs, in order to avoid the complexity of the drawing.

Referring to FIGS. 1 to 6, the semiconductor device may include a lower circuit pattern, a common source plate (CSP), a gate electrode structure, first to fifth division patterns 330, 620, 625, 470 and 475, an insulation pattern structure 600, a lower memory channel structure 462, a dummy memory channel structure 464, an upper memory channel structure 466, first to eighth upper contact plugs 632, 634, 636, 682, 684, 686, 688 and 690, a through via 655, and first to fifth upper wirings 632, 634, 636, 682, 684, 686, 688 and 690 on a substrate 100. As used herein, the term "dummy" is used to refer to a component that has the same or similar structure and shape as other components but does not have a substantial function and exists only as a pattern in the device.

Additionally, the semiconductor device may include a first support layer 300, a first support pattern 305, a first sacrificial layer structure 290, a channel connection pattern 510, a second lower blocking pattern 615, first and fourth insulation patterns 315 and 650, a protection layer 580, a third etch stop layer 910, first to fourth insulating interlayers 150, 170, 340 and 350, and sixth to eleventh insulating interlayers 900, 940, 950, 960, 970 and 980.

The substrate 100 may include or may be formed of a semiconductor material, e.g., silicon, germanium, silicon-germanium, etc., or a III-V group compound semiconductor, e.g., GaP, GaAs, GaSb, etc. In example embodiments, the substrate 100 may be a silicon-on-insulator (SOI) substrate or a germanium-on-insulator (GOI) substrate.

In example embodiments, the substrate 100 may include a first region I and a second region II surrounding the first region I. In example embodiments, the first region I may be a cell array region, and the second region II may be a pad region or an extension region. The first and second regions I and II of the substrate 100 may form a cell region.

Particularly, memory cells each of which includes a gate electrode, a channel and a charge storage structure may be formed on the first region I of the substrate 100, and upper contact plugs for applying electrical signals to the memory cells and pads of the gate electrodes contacting the upper contact plugs may be formed on the second region II of the substrate 100. FIG. 1 shows that the second region II of the substrate 100 entirely surrounds the first region I of the substrate 100, however, the inventive concept may not be limited thereto, and for example, the second region II of the substrate 100 may be formed only at opposite sides of the first region I of the substrate 100 in the second direction D2.

In some embodiments, the substrate 100 may further include a third region surrounding the second region II, and upper circuit patterns for applying electrical signals to the memory cells through the upper contact plugs may be formed on the third region of the substrate 100.

The substrate 100 may include a field region on which an isolation pattern 110 is formed, and an active region 101 on which no isolation pattern is formed. The isolation pattern 110 may include or may be formed of an oxide, e.g., silicon oxide.

In example embodiments, the semiconductor device may have a cell over periphery (COP) structure. That is, the lower circuit pattern may be formed on the substrate 100, and the memory cells, the upper contact plugs and the upper circuit pattern may be formed over the lower circuit pattern. The lower circuit pattern may include, e.g., transistors, lower contact plugs, lower wirings, lower vias, etc.

For example, first and second transistors may be formed on the second and first regions II and I, respectively, of the substrate 100. The first transistor may include a first lower gate structure 142 on the substrate 100, and first and second impurity regions 102 and 103 at upper portions, respectively, of the substrate 100 adjacent to the first lower gate structure 142, which may serve as source/drains, respectively. The second transistor may include a second lower gate structure 146 on the substrate 100, and third and fourth impurity regions 106 and 107 at upper portions, respectively, of the substrate 100 adjacent to the second lower gate structure 146, which may serve as source/drains, respectively.

The first lower gate structure 142 may include a first lower gate insulation pattern 122 and a first lower gate electrode 132 stacked on the substrate 100, and the second lower gate structure 146 may include a second lower gate insulation pattern 126 and a second lower gate electrode 136 stacked on the substrate 100.

The first insulating interlayer 150 may be formed on the substrate 100, and may cover the first and second transistors. First, second, fourth and fifth lower contact plugs 162, 163, 168 and 169 may extend through the first insulating interlayer 150 to contact the first to fourth impurity regions 102, 103, 106 and 107, respectively, and a third lower contact plug 164 may extend through the first insulating interlayer 150 to contact the first lower gate electrode 132. In some embodiments, a sixth lower contact plug (not shown) may extend through the first insulating interlayer 150 to contact the second lower gate electrode 136.

First to fifth lower wirings 182, 183, 184, 188 and 189 may be formed on the first insulating interlayer 150 to contact upper surfaces of the first to fifth lower contact plugs 162, 163, 164, 168 and 169, respectively. A first lower via 192, a sixth lower wiring 202, a third lower via 212 and an eighth lower wiring 222 may be sequentially stacked on the first lower via 182. A second lower via 196, a seventh lower wiring 206, a fourth lower via 216 and a ninth lower wiring 226 may be sequentially stacked on the fourth lower wiring 188.

The second insulating interlayer 170 may be formed on the first insulating interlayer 150, and may cover the first to ninth lower wiring 182, 183, 184, 188, 189, 202, 206, 222 and 226, and the first to fourth lower vias 192, 196, 212 and 216.

Each of the first and second insulating interlayers 150 and 170 may include or may be formed of an oxide, e.g., silicon oxide.

The CSP 240 may be formed on the second insulating interlayer 170. The CSP 240 may include, e.g., polysilicon doped with n-type impurities. Alternatively, the CSP 240 may include a metal silicide layer and a doped polysilicon layer sequentially stacked. The metal silicide layer may include or may be formed of, e.g., tungsten silicide. In some embodiments, the CSP 240 may be connected to ground.

The first sacrificial layer structure 290, the channel connection pattern 510, the first support layer 300 and the first support pattern 305 may be formed on the CSP 240.

The channel connection pattern 510 may be formed on the first region I of the substrate 100, and the first sacrificial layer structure 290 may be formed on the second region II of the substrate 100. The channel connection pattern 510 may include an air gap 515 therein. The phrase "air gap" will be understood to include gaps (e.g., pockets) of air or gases other than air, such as other atmospheric gases or chamber gases that may be present during manufacturing.

The first support layer 300 may be formed on the channel connection pattern 510 and the first sacrificial layer structure 290, and may also be formed in a first opening 302 extending through the channel connection pattern 510 and the first sacrificial layer structure 290 to expose an upper surface of the CSP 240, which may be referred to as the first support pattern 305.

The first support pattern 305 may have various layouts in a plan view. For example, the first support pattern 305 may include a plurality of support patterns that may be spaced apart from each other in the second and third directions D2 and D3 on the first region I of the substrate 100, a support pattern that may extend in the third direction D3 on a portion of the second region II of the substrate 100 adjacent to the first region I of the substrate 100, and a plurality of first support patterns each of which may extend in the second direction D2 and that may be spaced apart from each other in the third direction D3 on the second region II of the substrate 100. For the simplicity of drawing, FIG. 3 shows the first support pattern 305 extending in the third direction D3 on the portion of the second region II of the substrate 100 adjacent to the first region I of the substrate 100.

The channel connection pattern 510 may include polysilicon doped with n-type impurities or undoped polysilicon. The first sacrificial layer structure 290 may include first, second and third sacrificial layers 260, 270 and 280 sequentially stacked in the first direction D1. Each of the first and third sacrificial layers 260 and 280 may include an oxide, e.g., silicon oxide, and the second sacrificial layer 270 may include a nitride, e.g., silicon nitride. The first support layer 300 and the first support pattern 305 may include a material having etching selectivity with respect to the first to third sacrificial layers 260, 270 and 280, e.g., polysilicon doped with n-type impurities.

The gate electrode structure may include gate electrodes at a plurality of levels spaced apart from each other in the first direction D1 on the first support layer 300 and the first support pattern 305. Each of the gate electrodes may extend in the second direction D2.

In example embodiments, the gate electrode structure may include first, second and third gate electrodes 752, 754 and 925 sequentially stacked in the first direction D1. The first gate electrode 752 may be formed at one or two levels, the second gate electrodes 754 may be formed at a plurality of levels, respectively, and the third gate electrode 925 may be formed at one or two levels. FIGS. 3 to 6 show that each of the first gate electrode 752 and the third gate electrode 756 is formed at one level, however, the inventive concept may not be limited thereto.

In example embodiments, the first gate electrode 752 may serve as a ground selection line (GSL), the second gate electrode 754 may serve as a word line, and the third gate electrode 925 may serve as a string selection line (SSL).

Each of the first and second gate electrodes 752 and 754 may include a gate conductive pattern and a gate barrier pattern covering a surface of the gate conductive pattern. The gate conductive pattern may include or may be formed of a metal having a low resistance, e.g., tungsten, titanium, tantalum, platinum, etc., and the gate barrier pattern may include or may be formed of a metal nitride, e.g., titanium nitride, tantalum nitride, etc. In example embodiments, the third gate electrode 925 may include or may be formed of, e.g., polysilicon doped with n-type impurities.

The first insulation pattern 315 may be formed between the first and second gate electrodes 752 and 754, between the second gate electrodes 754, and between the first gate electrode 752 and the first support layer 300 or the first support pattern 305. The first insulation pattern 315 may include or may be formed of an oxide, e.g., silicon oxide.

In example embodiments, the gate electrode structure may have a staircase shape on the second region II of the substrate 100. In the staircase shape of the gate electrode structure, lengths, in the second direction D2, of gate electrodes in the gate electrode structure may decrease from a lowermost level toward an uppermost level in the first direction D1, and the gate electrodes may be configured to have steps arranged in the second direction D2 on the second region II of the substrate 100. The gate electrode structure may further include steps arranged in the third direction D3 on the second region II of the substrate 100.

Hereinafter, a portion of the gate electrode structure corresponding to the step, that is, an end portion of each of the gate electrodes that is not overlapped by upper ones of the gate electrodes may be referred to as a pad. Thus, the pad of each of the gate electrodes may be formed on the second region II of the substrate 100.

The gate electrode structure may include first pads having a relatively large length in the second direction D2 and second pads having a relatively small length in the second direction D2. The numbers of the first pads and the second pads may not be limited.

In example embodiments, a plurality of gate electrode structures may be spaced apart from each other in the third direction D3. The second division pattern 620 may be formed on the CSP 240 between neighboring ones of the gate electrode structures in the third direction D3. In some embodiments, each of the gate electrode structure may be interposed between two adjacent second division patterns 620 that are spaced apart from each other in the third direction D3. The second division pattern 620 may extend in the second direction D2 on the first and second regions I and II of the substrate 100.

The third division pattern 625 may extend through the gate electrode structure in the second direction D2 on the first region I of the substrate 100 and a portion of the second region II of the substrate 100 adjacent to the first region I of the substrate 100. Unlike the second division pattern 620, the third division pattern 625 may not extend to an end portion of the second region II of the substrate 100, and a plurality of third division patterns 625 may be spaced apart from each other in the second direction D2 on the second region II of the substrate 100.

In example embodiments, each of the second and third division patterns 620 and 625 may include a lower portion and an upper portion stacked in the first direction D1, and an upper surface of the lower portion of each of the second and third division patterns 620 and 625 may be substantially coplanar with upper surfaces of the fourth insulating interlayer 350, the lower memory channel structure 462 and the dummy memory channel structure 464.

In example embodiments, the lower portion of the second division pattern 620 may extend in the second direction D2 on the first and second regions I and II of the substrate 100, and a plurality of upper portions of the second division pattern 620 may be spaced apart from each other in the second direction D2 on the first and second regions I and II of the substrate 100. A plurality of lower portions of the third division patterns 625 may be spaced apart from each other in the second direction D2 on the first and second regions I and II of the substrate 100, and a plurality of upper portions of the third division pattern 625 may be spaced apart from each other in the second direction D2 on the first and second regions I and II of the substrate 100.

Referring to FIG. 5A, a width in the third direction D3 of the upper portion of each of the second and third division patterns 620 and 625 may be substantially the same as a width in the third direction D3 of the lower portion of a corresponding one of the second and third division patterns 620 and 625 on the first region I of the substrate 100, while a width in the third direction D3 of the upper portion of each of the second and third division patterns 620 and 625 may be greater than a width in the third direction D3 of the lower portion of a corresponding one of the second and third division patterns 620 and 625 on the second region II of the substrate 100 except for a portion of the second region II of the substrate 100 adjacent to the first region I of the substrate 100.

Alternatively, referring to FIG. 5B, the width in the third direction D3 of the upper portion of each of the second and third division patterns 620 and 625 may be less than the width in the third direction D3 of the lower portion of a corresponding one of the second and third division patterns 620 and 625 on the first region I of the substrate 100, while the width in the third direction D3 of the upper portion of each of the second and third division patterns 620 and 625 may be greater than the width in the third direction D3 of the lower portion of a corresponding one of the second and third division patterns 620 and 625 on the second region II of the substrate 100 except for the portion of the second region II of the substrate 100 adjacent to the first region I of the substrate 100.

The first division pattern 330 may extend through the first gate electrode 752 on the second region II of the substrate 100. A plurality of first division patterns 330 may be spaced apart from each other in the second and third directions D2 and D3. In example embodiments, the first division pattern 330 may contact an end portion in the second direction D2 of the third division pattern 625, and may overlap in the first direction D2 an end portion in the second direction D2 of the insulation pattern structure 600. The term "contact," as used herein, refers to a direct connection (i.e., touching) unless the context indicates otherwise.

The fourth division pattern 470 may extend in the second direction D2 between the second and third division patterns 620 and 625 through the sixth insulating interlayer 900, the third etch stop layer 910 and the third gate electrode 925 on the first region I of the substrate 100 and the portion of the second region II of the substrate 100 adjacent thereto.

The fifth division pattern 475 may extend in the second direction D2 on the first region I of the substrate 100 and the portion of the second region II of the substrate 100 adjacent thereto, and may contact each of opposite sidewalls in the third direction D3 of each of the second and third division patterns 620 and 625, or may contact each of opposite sidewalls in the third direction D3 of portions of the sixth insulating interlayer 900, the third etch stop layer 910 and the third support pattern 927 on each of the second and third division patterns 620 and 625. In some embodiments, a pair of fifth division patterns 475 may be disposed on the first region I of the substrate 100 and may be spaced apart from each other in the third direction D3. The pair of fifth division patterns 475 may contact opposite sidewalls of the second division pattern 620 or opposite sidewalls of the third division pattern 625.

Referring to FIG. 5A, the fifth division pattern 475 may contact upper surfaces of portions of the fourth insulating interlayer 350 and the second lower blocking pattern 615 adjacent to each of the second and third division patterns 620 and 625 in the third direction D3.

Referring to FIG. 5B, the fifth division pattern 475 may also contact an upper surface of an edge portion in the third direction D3 of a lower portion of each of the second and third division patterns 620 and 625.

Each of the first to fifth division patterns 330, 620, 625, 470 and 475 may include or may be formed of an oxide, e.g., silicon oxide.

The third support pattern 927 may include or may be formed of a material substantially the same as a material of the third gate electrode 925, and may be formed at a level substantially the same as a level of the third gate electrode 925. In example embodiments, a plurality of third support patterns 927 and a plurality of fourth support patterns 927-1 may be formed on the third etch stop layer 910 between neighboring ones of the fifth division patterns 475 in the third direction D3. The upper portion of the second division pattern 620 or the third division pattern 625 may be formed between neighboring ones of the fifth division patterns 475 in the second direction D2. In some embodiments, the fourth support patterns 927-1 may overlap the third division patterns 625 respectively in the first direction D1 (see, FIG. 5A and 5B). The plurality of third and fourth support patterns 927 and 927-1 may be formed by a same process, and may include or may be formed of the same material.

In example embodiments, a memory block including the gate electrode structure, the lower memory channel structures 462 and the upper memory channel structures 466 in an area defined by neighboring ones of the second division patterns 620 in the third direction D3 may form a memory block, and a plurality of memory blocks may be arranged in the third direction D3. In some embodiments, the memory block may be a unit of an erase operation performed on a NAND flash memory device. For example, the erase operation may be simultaneously performed on all memory cells in the memory block to erase the memory cells.

In an example embodiment, each of the memory blocks may include two first gate electrodes 752 at each level divided by the first division pattern 330, one second gate electrode 754 at each level, and four third gate electrodes 925 at each level divided by the third to fifth division patterns 625, 470 and 475, however, the inventive concept may not be limited thereto. Alternatively, the memory block may include two first gate electrodes 752 at each level, one second gate electrode 754 at each level, and six third gate electrodes 925 at each level.

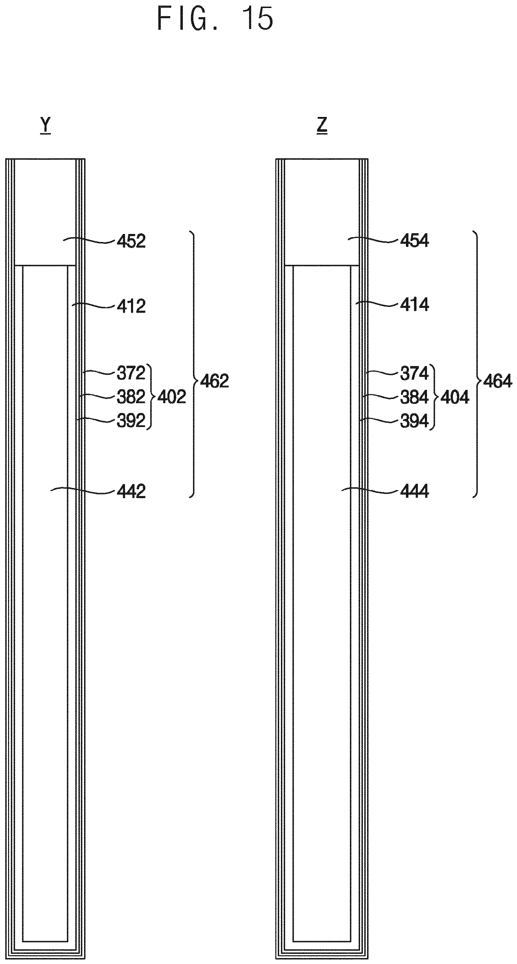

Referring FIGS. 1 to 6 together with FIG. 15, the lower memory channel structure 462 may be formed on the first region I of the substrate 100, and may contact an upper surface of the CSP 240. The lower memory channel structure 462 may extend through the channel connection pattern 510, the first and second gate electrodes 752 and 754, the first insulation pattern 315, and the third and fourth insulating interlayers 340 and 350. In example embodiments, the lower memory channel structure 462 may include a lower filling pattern 442 having a pillar shape extending in the first direction D1, a lower channel 412 on a sidewall of the lower filling pattern 442 and having a cup shape, a lower capping pattern 452 on upper surfaces of the lower filling pattern 442 and the lower channel 412, and a lower charge storage structure 402 on an outer sidewall of the lower channel 412 and a sidewall of the lower capping pattern 452.

The lower charge storage structure 402 may include a lower tunnel insulation pattern 392, a lower charge storage pattern 382 and a first lower blocking pattern 372 sequentially stacked in the horizontal direction on the outer sidewall of the lower channel 412.

In example embodiments, a plurality of lower memory channel structures 462 may be spaced apart from each other in the second and third directions D2 and D3 on the first region I of the substrate 100 to form a lower memory channel array, and a plurality of lower memory channel structures 462 included in the lower memory channel array may be connected to each other by the channel connection pattern 510. Particularly, the lower charge storage structure 402 may not be formed on a portion of the outer sidewall of each of the lower channels 412, and the channel connection pattern 510 may contact the outer sidewalls of the lower channels 412 to electrically connect the lower channels 412 to each other.

The dummy memory channel structure 464 may be formed on the second region II of the substrate 100, and may contact the upper surface of the CSP 240. The dummy memory channel structure 464 may extend through the first sacrificial layer structure 290, the first and second gate electrodes 752 and 754, the first insulation pattern 315, and the third and fourth insulating interlayers 340 and 350. In example embodiments, the dummy memory channel structure 464 may include a dummy filling pattern 444 having a pillar shape extending in the first direction D1, a dummy channel 414 on a sidewall of the dummy filling pattern 444 and having a cup shape, a dummy capping pattern 454 on upper surfaces of the dummy filling pattern 444 and the dummy channel 414, and a dummy charge storage structure 404 on an outer sidewall of the dummy channel 414 and a sidewall of the dummy capping pattern 454.

The dummy charge storage structure 404 may include a dummy tunnel insulation pattern 394, a dummy charge storage pattern 384 and a dummy blocking pattern 374 sequentially stacked in the horizontal direction on the outer sidewall of the dummy channel 414.

The dummy memory channel structure 464 may not serve as memory unit for storing data or a channel through which charge carriers move, but may prevent the gate electrode structure from being collapsing, and thus may be referred to as a support structure 464.

In example embodiments, a plurality of support structures 464 may be spaced apart from each other in the second and third directions D2 and D3 on the second region II of the substrate 100.

The upper memory channel structure 466 may include an upper filling pattern 446, an upper channel 416, an upper charge storage structure 406 and an upper capping pattern 456. In example embodiments, the upper channel 416 may extend through the sixth insulating interlayer 900 and the third etch stop layer 910 to contact an upper surface of the lower memory channel structure 462, and may partially extend through the third gate electrode 925.

In example embodiments, the upper channel 416 may include a lower portion extending through the sixth insulating interlayer 900 and having a first width, a middle portion extending through the third etch stop layer 910 and having a second width, and an upper portion partially extending through the third gate electrode 925 and having a third width. The third width may be greater than the second width, and the first width may be greater than the second width. The upper portion of the upper channel 416 may have a cup shape, and the upper filling pattern 446 may fill a space formed by the upper portion of the upper channel 416.

The upper charge storage structure 406 may extend through the third gate electrode 925, and may cover a sidewall and a lower surface of an edge portion of the upper portion of the upper channel 416 and a sidewall of the upper capping pattern 456. The upper charge storage structure 406 may include an upper tunnel insulation pattern, an upper charge storage pattern and a first upper blocking pattern sequentially stacked on an outer sidewall of the upper channel 416 in the horizontal direction.

The upper capping pattern 456 may contact upper surfaces of the upper filling pattern 446 and the upper portion of the upper channel 416, and may contact an inner sidewall of the upper charge storage structure 406.

In example embodiments, the upper memory channel structure 466 may contact the lower memory channel structure 462, and thus a plurality of upper memory channel structures 466 may be spaced apart from each other in the second and third directions D2 and D3 on the first region I of the substrate 100 to form an upper memory channel array.

The lower channel 412, the upper channel 416 and the dummy channel 414 may include or may be formed of, e.g., undoped polysilicon, the lower filling pattern 442, the upper filling pattern 446 and the dummy filling pattern 444 may include or may be formed of an oxide, e.g., silicon oxide, and the lower capping pattern 452, the upper capping pattern 456 and the dummy capping pattern 454 may include or may be formed of, e.g., doped polysilicon.

The lower tunnel insulation pattern 392, the upper tunnel insulation pattern 396 and the dummy tunnel insulation pattern 394 may include or may be formed of an oxide, e.g., silicon oxide, the lower charge storage pattern 382, the upper charge storage pattern and the dummy charge storage pattern 384 may include or may be formed of a nitride, e.g., silicon nitride, and the first lower blocking pattern 372, the first upper blocking pattern and the dummy blocking pattern 374 may include or may be formed of an oxide, e.g., silicon oxide.

The insulation pattern structure 600 may extend through a portion of the gate electrode structure on the second region II of the substrate 100, and may have a shape of, e.g., a rectangle, an ellipse, a circle, etc., in a plan view. In example embodiments, the insulation pattern structure 600 may extend through the second pad of the gate electrode structure having a relatively large length in the second direction D2. The insulation pattern structure 600 may include second and third insulation patterns 317 and 327 alternately and repeatedly stacked in the first direction D1.

The second lower blocking pattern 615 may cover lower and upper surfaces and a sidewall facing the lower memory channel structure 462 and the support structure 464 of each of the first and second gate electrodes 752 and 754. The second lower blocking pattern 615 may include or may be formed of a metal oxide, e.g., aluminum oxide, hafnium oxide, etc.

The protection layer 580 may be formed on an upper surface of a portion of the CSP 240 adjacent to the second and third division patterns 620 and 625, a sidewall of the channel connection pattern 510, sidewalls of the first support layer 300 and the first support pattern 305, and a sidewall of the upper portion of each of the second and third division patterns 620 and 625. The protection layer 580 may include or may be formed of an oxide, e.g., silicon oxide.

The third insulating interlayer 340 may be formed on the first support layer 300, and may cover sidewalls of the first and second gate electrodes 752 and 754 and the first insulation pattern 315, and the fourth insulating interlayer 350 may be formed on the third insulating interlayer 340 and the first insulation pattern 315.

The seventh to eleventh insulating interlayers 940, 950, 960, 970 and 980 may be sequentially stacked on the fourth insulating interlayer 350.

The first and second upper contact plugs 632 and 634 may extend through the third, fourth, seventh and eighth insulating interlayers 340, 350, 940 and 950 and the first insulation pattern 315 to contact upper surfaces of the pads of the first and second gate electrodes 752 and 754, respectively, and the third upper contact plug 636 may extend through the eighth insulating interlayer 950 to contact an upper surface of the pad of the third gate electrode 925 on the second region II of the substrate 100.

In example embodiments, each of the first to third upper contact plugs 632, 634 and 636 may be formed in an area surrounded by the support structures 464 at each of the pads of the gate electrode structure. For example, the support structures 464 may be disposed at respective vertices of a rectangle in a plan view, and each of the first to third upper contact plugs 632, 634 and 636 may be formed in an inside of the rectangle in a plan view.

FIG. 2 shows the layout of the first to third upper contact plugs 632, 634 and 636, however, the inventive concept may not be limited thereto. In the layout of FIG. 2, the first division pattern 330, the second division pattern 620, the third division pattern 625, the fourth division pattern 470, and the fifth division pattern 475 are shown. In the layout, the third support patterns 927 and fourth support patterns 927-1 are also shown. The plurality of third support patterns 927 may be arranged along a first straight line extending in the second direction D2. The second division pattern 620 may extend along the first straight line such that the second division pattern 620 and the plurality of third support patterns 927 may be arranged along the first straight line. In some embodiments, the plurality of fourth support patterns 927-1 may be spaced apart from each other in the second direction D2. The third division pattern 625 and the plurality of fourth support patterns 927-1 may be arranged along a second straight line extending in the second direction D2. The second straight line may be spaced apart from the first straight line in the third direction D3. In some embodiments, the third and fourth support patterns 927 and 927-1 may be arranged in a zigzag pattern along a third straight line extending in the third direction D3.

The through via 655 may extend through the third, fourth, seventh and eighth insulating interlayers 340, 350, 940, 950 and 960, the insulation pattern structure 600, the first support layer 300, the first sacrificial layer structure 290, the CSP 240, and an upper portion of the second insulating interlayer 170 on the second region II of the substrate 100, and may contact an upper surface of the eighth lower wiring 222.

In example embodiments, a plurality of through vias 655 may be spaced apart from each other in an area where the insulation pattern structure 600 is formed. FIG. 2 shows six through vias 655 in each area, however, the inventive concept may not be limited thereto.

The fourth insulation pattern 650 may be formed on a sidewall of the through via 655, and may be electrically connected to the first support layer 300 and the CSP 240. However, the through via 655 may extend through the insulation pattern structure 600, that is, the second and third insulation patterns 317 and 327 to be electrically insulated from the first and second gate electrodes 752 and 754, and thus if an insulation pattern is formed on sidewalls of the first support layer 300 and the CSP 240, the fourth insulation pattern 650 may not be formed. The fourth insulation pattern 650 may include or may be formed of an oxide, e.g., silicon oxide.

The fourth to sixth upper contact plugs 682, 684 and 686 may extend through the ninth and tenth insulating interlayers 960 and 970, and may contact upper surfaces of the first to third upper contact plugs 632, 634 and 636, respectively. The seventh upper contact plug 688 may extend through the tenth insulating interlayer 970, and may contact an upper surface of the through via 655. The eighth upper contact plug 690 may extend through the eighth to tenth insulating interlayers 950, 960 and 970, and may contact an upper surface of the upper memory channel structure 466.

The first to fifth upper wirings 712, 714, 716, 718 and 720 may extend through the eleventh insulating interlayer 980, and may contact upper surfaces of the fourth to eighth upper contact plugs 682, 684, 686, 688 and 690, respectively.

In example embodiments, the fifth upper wiring 720 may extend in the third direction D3, and a plurality of fifth upper wirings 720 may be spaced apart from each other in the second direction D2. The fifth upper wiring 720 may serve as a bit line. Alternatively, an upper via and a sixth upper wiring may be further formed on the fifth upper wiring 720, and the sixth upper wiring may serve as the bit line.

The first to fifth upper wirings 712, 714, 716, 718 and 720 may have various layouts on the second region II of the substrate 100.

The first to sixth upper contact plugs 632, 634, 636, 682, 684 and 686, the through via 655, and the first to fifth upper wirings 712, 714, 716, 718 and 720 may include or may be formed of a conductive material, e.g., a metal, a metal nitride, a metal silicide, etc.

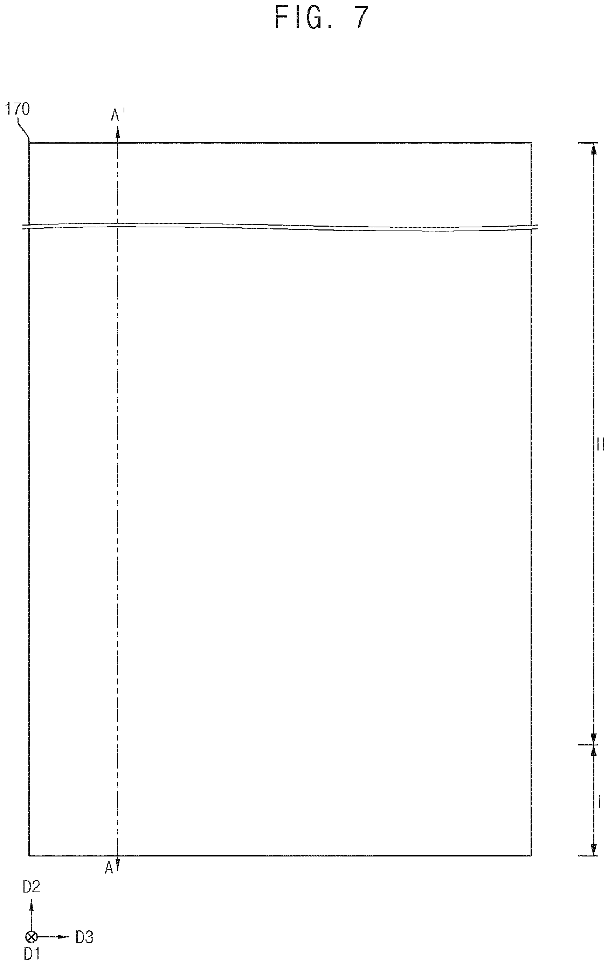

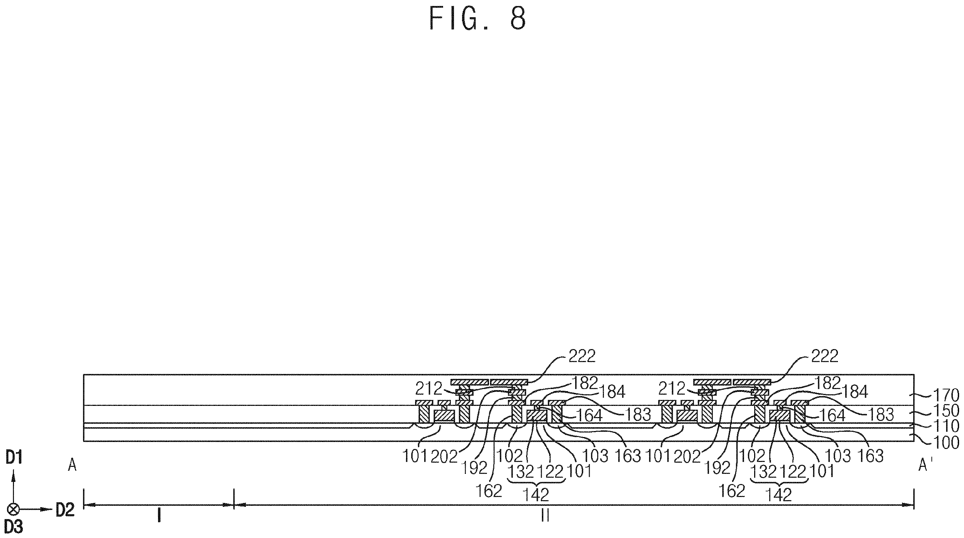

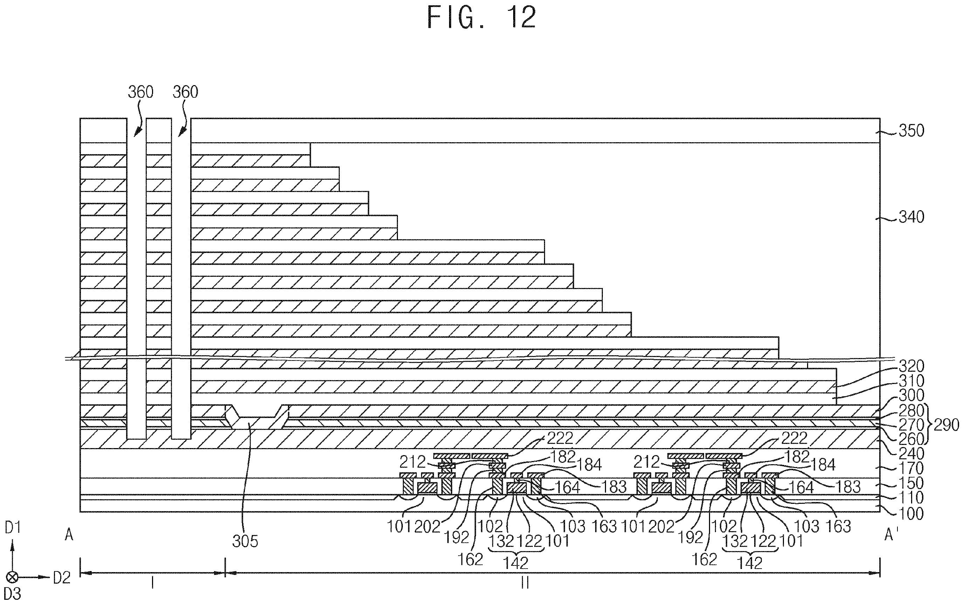

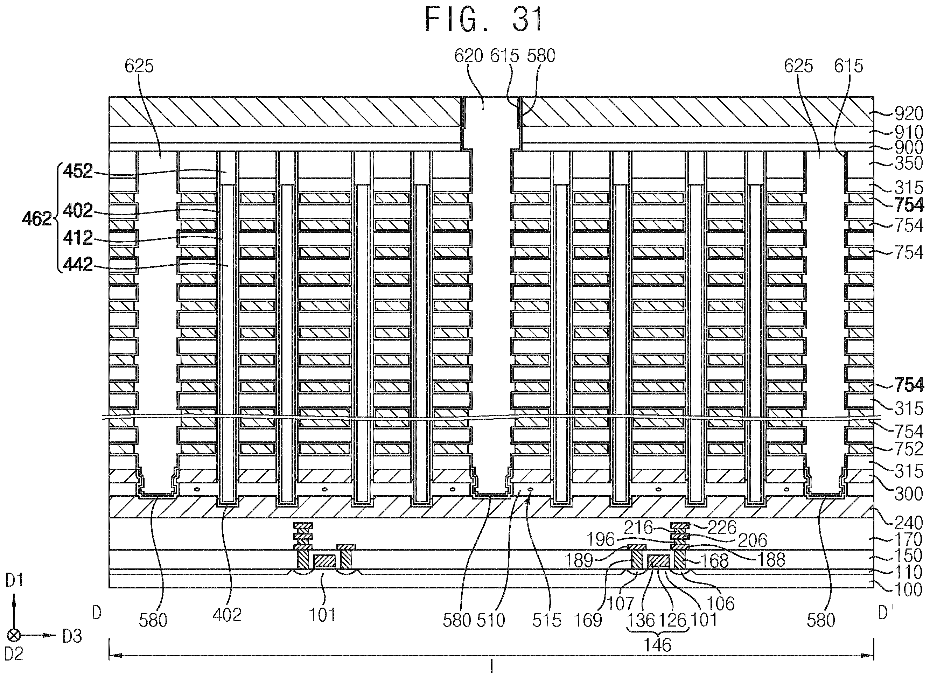

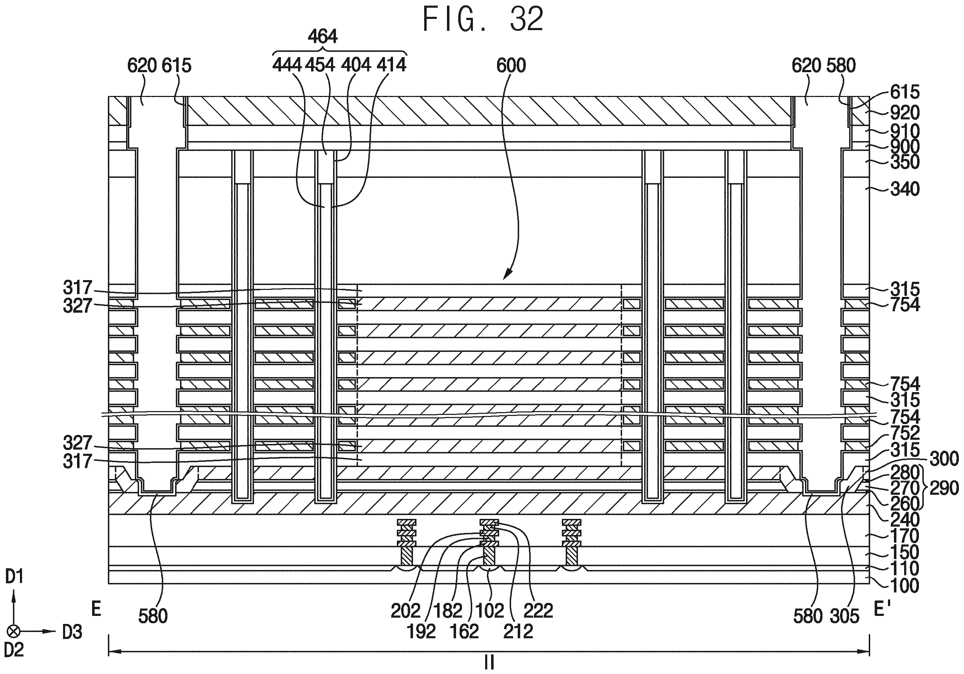

FIGS. 7 to 43 are plan views and cross-sectional views illustrating a method of manufacturing a semiconductor device, for example, a vertical channel NAND flash memory device in accordance with example embodiments. Particularly, FIGS. 7, 11, 16, 21, 23, 30, 33, 35, 38, 40 and 42 are the plan views, and FIGS. 8-10, 12-15, 17-20, 22, 24-29, 31-32, 34, 36-37, 39, 41 and 43 are the cross-sectional views.

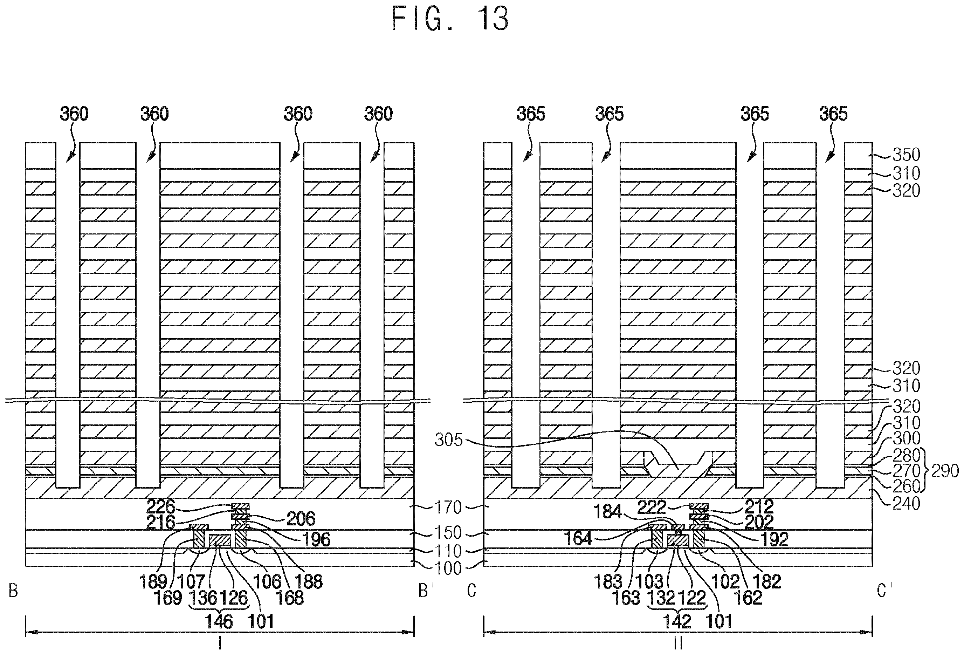

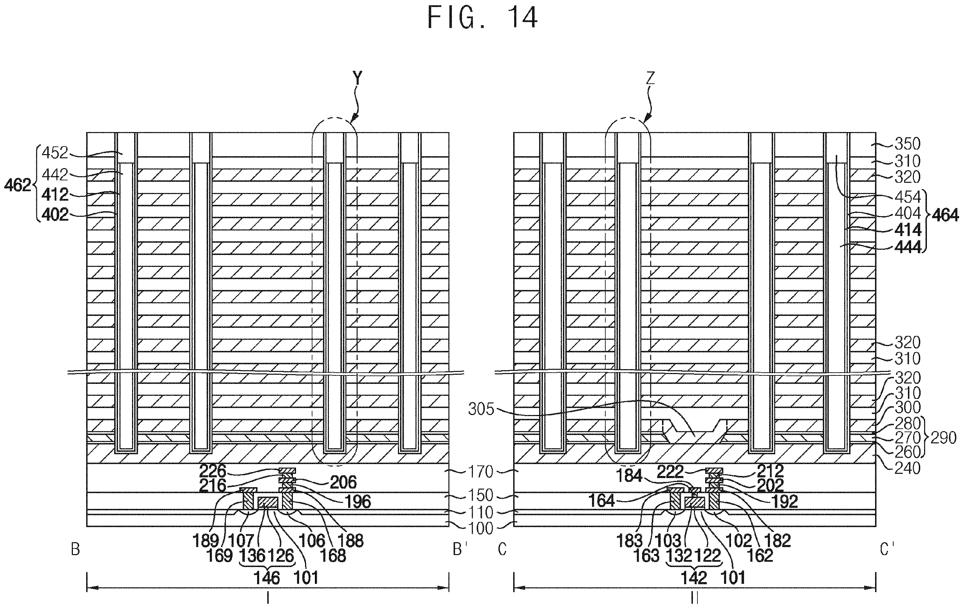

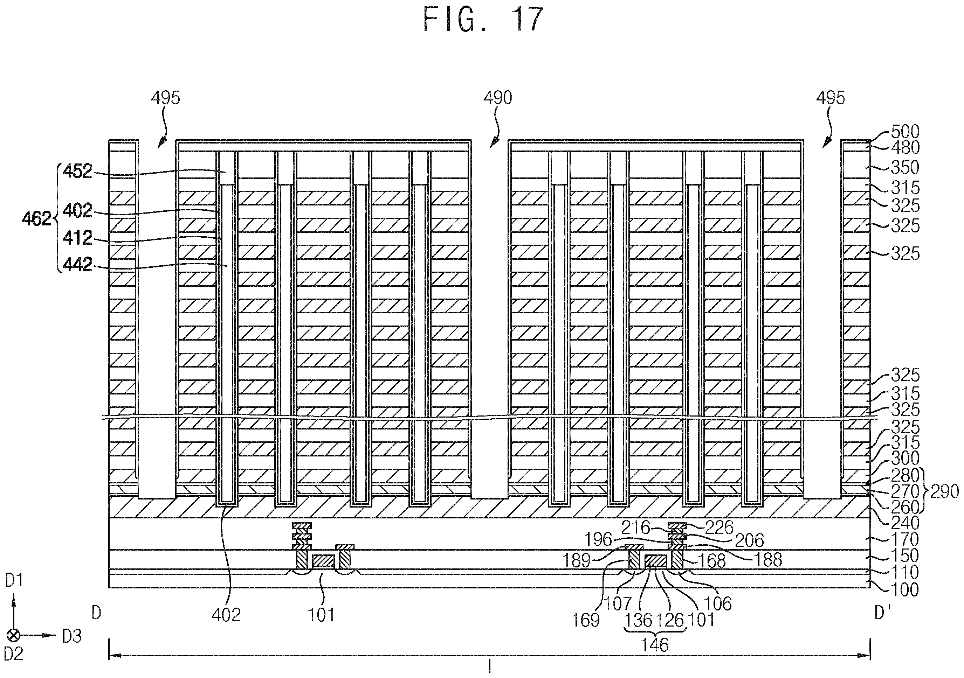

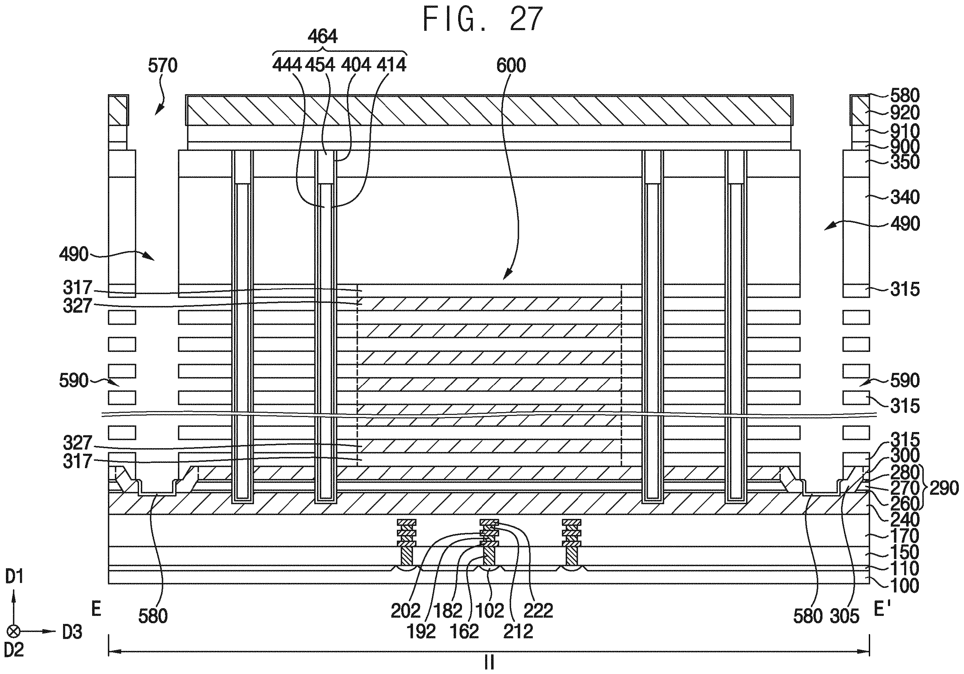

FIGS. 8, 9, 10, 12, 41 and 43 are cross-sectional views taken along lines A-A' of corresponding plan views, respectively, each of FIGS. 13-15 shows cross-sectional views taken along lines B-B' and C-C' of corresponding plan views, respectively, FIGS 17-20, 22, 24-26, 28, 31, 34, 36-37 and 39 are cross-sectional views taken along lines D-D' of corresponding plan views, respectively, and FIGS. 27, 29 and 32 are cross-sectional views taken along lines E-E' of corresponding plan views, respectively. FIGS. 7 to 43 are drawings of region X of FIG. 1, and FIG. 15 shows enlarged cross-sectional views of regions Y and Z of FIG. 14.

Referring to FIGS. 7 and 8, a lower circuit pattern may be formed on a substrate 100, and first and second insulating interlayers 150 and 170 covering the lower circuit pattern may be sequentially stacked on the substrate 100.

The substrate 100 may include a field region on which an isolation pattern 110 is formed, and an active region 101 on which no isolation pattern is formed.

The lower circuit pattern may include or may be formed of, e.g., transistors, lower contact plugs, lower wirings, lower vias, etc.

Referring to FIGS. 7 and 8 together with FIG. 13, for example, first and second transistors may be formed on the second and first regions II and I, respectively, of the substrate 100. The first transistor may include a first lower gate structure 142 on the substrate 100, and first and second impurity regions 102 and 103 at upper portions, respectively, of the substrate 100 adjacent to the first lower gate structure 142, which may serve as source/drains, respectively. The second transistor may include a second lower gate structure 146 on the substrate 100, and third and fourth impurity regions 106 and 107 at upper portions, respectively, of the substrate 100 adjacent to the second lower gate structure 146, which may serve as source/drains, respectively.

The first insulating interlayer 150 may be formed on the substrate 100, and may cover the first and second transistors. First, second, fourth and fifth lower contact plugs 162, 163, 168 and 169 may extend through the first insulating interlayer 150 to contact the first to fourth impurity regions 102, 103, 106 and 107, respectively, and a third lower contact plug 164 may extend through the first insulating interlayer 150 to contact the first lower gate electrode 132. In some embodiments, a sixth lower contact plug (not shown) may extend through the first insulating interlayer 150 to contact the second lower gate electrode 136.

First to fifth lower wirings 182, 183, 184, 188 and 189 may be formed on the first insulating interlayer 150 to contact upper surfaces of the first to fifth lower contact plugs 162, 163, 164, 168 and 169, respectively. A first lower via 192, a sixth lower wiring 202, a third lower via 212 and an eighth lower wiring 222 may be sequentially stacked on the first lower via 182, and a second lower via 196, a seventh lower wiring 206, a fourth lower via 216 and a ninth lower wiring 226 may be sequentially stacked on the fourth lower wiring 188.

The second insulating interlayer 170 may be formed on the first insulating interlayer 150, and may cover the first to ninth lower wiring 182, 183, 184, 188, 189, 202, 206, 222 and 226, and the first to fourth lower vias 192, 196, 212 and 216.

Each element of the lower circuit pattern may be formed by a patterning process or a damascene process.

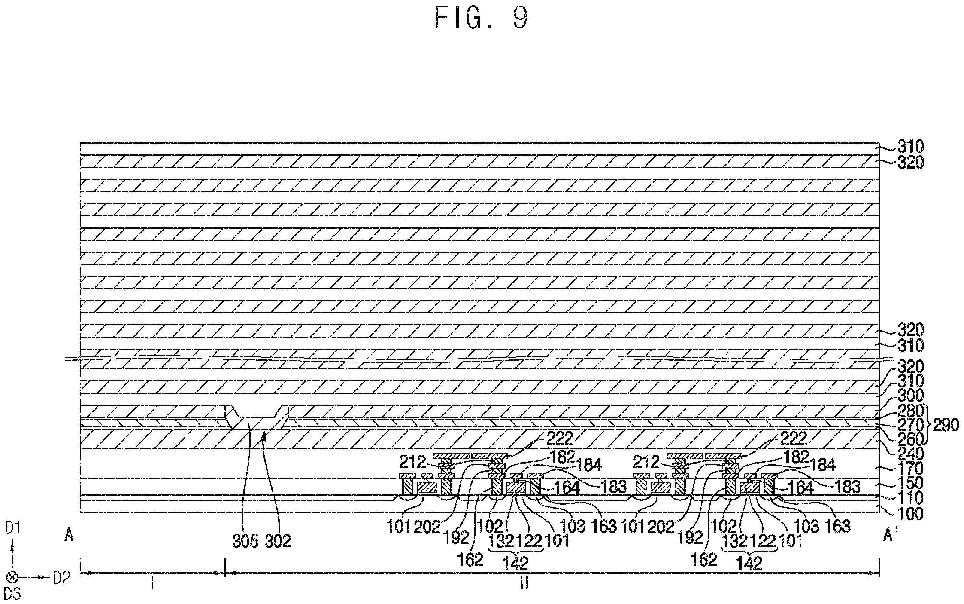

Referring to FIG. 9, a CSP 240 and a first sacrificial layer structure 290 may be formed on the second insulating interlayer 170, the first sacrificial layer structure 290 may be partially removed to form a first opening 302 exposing an upper surface of the CSP 240, and a first support layer 300 may be formed on an upper surface of the first sacrificial layer structure 290 and the exposed upper surface of the CSP 240.

The first sacrificial layer structure 290 may include first, second and third sacrificial layers 260, 270 and 280 sequentially stacked. Each of the first and third sacrificial layers 260 and 280 may include or may be formed of an oxide, e.g., silicon oxide, and the second sacrificial layer 270 may include or may be formed of a nitride, e.g., silicon nitride.

The first opening 302 may have various layouts in a plan view. For example, a plurality of first openings 302 may be spaced apart from each other in the second and third directions D2 and D3 on the first region I of the substrate 100, the first opening 302 may extend in the third direction D3 on a portion of the second region II of the substrate 100 adjacent to the first region I of the substrate 100, and a plurality of first openings 302, each of which may extend in the second direction D2, may be spaced apart from each other in the third direction D3 on the second region II of the substrate 100. FIG. 9 shows the first opening 302 extending in the third direction D3 on the portion of the second region II of the substrate 100 adjacent to the first region I of the substrate 100.

The first support layer 300 may include or may be formed of a material having etching selectivity with respect to the first to third sacrificial layers 260, 270 and 280, e.g., polysilicon doped with n-type impurities. The first support layer 300 may have a constant thickness, and thus a first recess may be formed on a portion of the first support layer 300 in the first opening 302. Hereinafter, the portion of the first support layer 300 in the first opening 302 may be referred to as a first support pattern 305.

An insulation layer 310 and a fourth sacrificial layer 320 may be alternately and repeatedly stacked on the first support layer 300 and the first support pattern 305 in the first direction D1, and a mold layer including the insulation layers 310 and the fourth sacrificial layers 320 may be formed. The insulation layer 310 may include or may be formed of an oxide, e.g., silicon oxide, and the fourth sacrificial layer 320 may include or may be formed of a material having etching selectivity with respect to the insulation layer 310, e.g., a nitride such as silicon nitride.

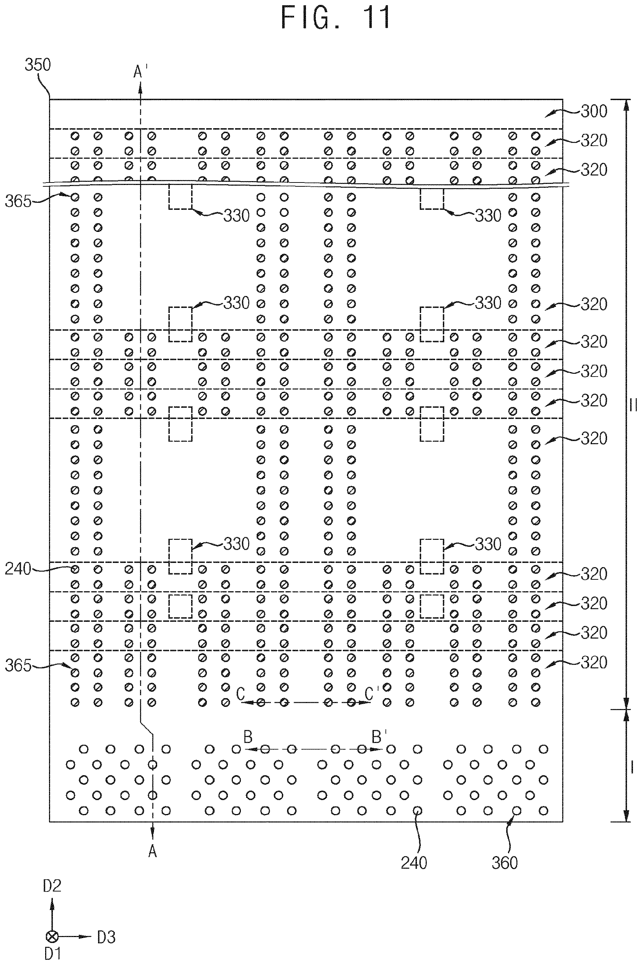

However, referring to FIG. 9 together with FIG. 11, a first division pattern 330 extending through a lowermost one of the fourth sacrificial layers 320 may be formed. The first division pattern 330 may be formed on the second region II of the substrate 100. In example embodiments, a plurality of first division patterns 330 may be spaced apart from each other in the second and third directions D2 and D3.

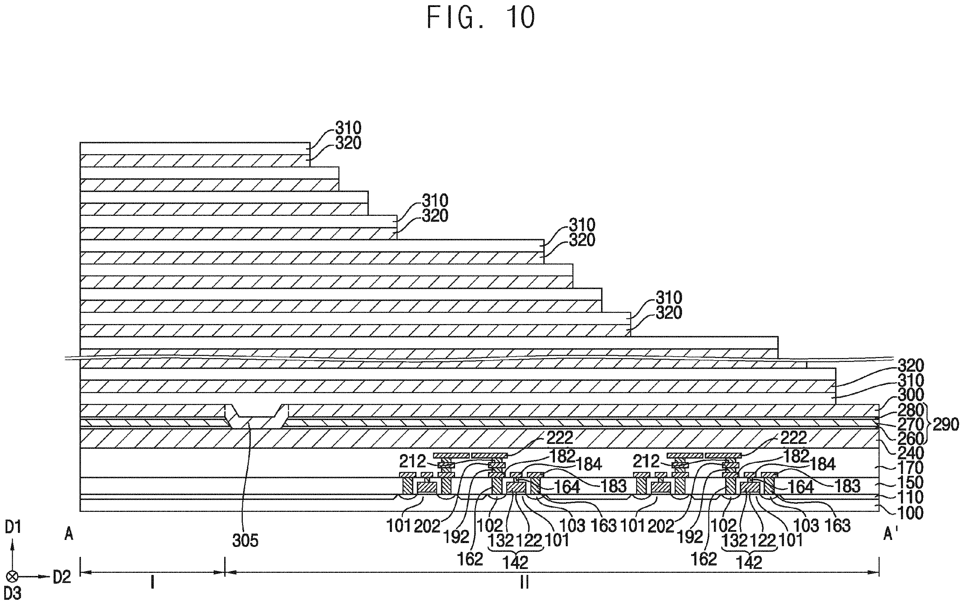

Referring to FIG. 10, a photoresist pattern partially covering an uppermost one of the insulation layers 310 may be formed, and the uppermost one of the insulation layers 310 and an uppermost one of the fourth sacrificial layers 320 may be etched using the photoresist pattern as an etching mask. Thus, a portion of one of the insulation layers 310 directly under the uppermost one of the fourth sacrificial layers 320 may be exposed.

After performing a trimming process for reducing an area of the photoresist pattern, the uppermost one of the insulation layers 310, the uppermost one of the fourth sacrificial layers 320, the exposed one of the insulation layers 310 and one of the fourth sacrificial layer 320 directly under the exposed one of the insulation layers 310 may be etched by an etching process using the reduced photoresist pattern as an etching mask. The trimming process and the etching process may be repeatedly performed to form a mold having a staircase shape and including a plurality of step layers each of which may include one fourth sacrificial layer 320 and one insulation layer 310 sequentially stacked.

Hereinafter, the "step layer" may refer to all portions of the fourth sacrificial layer 320 and the insulation layer 310 at the same level, which may include an unexposed portion as well as an exposed portion of the fourth sacrificial layer 320 and the insulation layer 310, and a "step" may refer to only the exposed portion of the "step layer." In example embodiments, the steps may be arranged in the second direction D2. Alternatively, the steps may be arranged in the third direction D3.

In example embodiments, lengths in the second direction of the steps included in the mold may be constant except for some ones. Lengths in the second direction D2 of some ones of the steps may be greater than a length in the second direction D2 of other ones of the steps, and hereinafter, ones of the steps having a relatively small length in the second direction D2 may be referred to as first steps, and ones of the steps having a relatively large length in the second direction D2 may be referred to as second steps. FIG. 10 shows two second steps. In plan views hereinafter, the steps are shown by dotted lines.

The mold may be formed on the first support layer 300 and the first support pattern 305 on the first and second regions I and II of the substrate 100, and an upper surface of an edge portion of the first support layer 300 may not be covered by the mold, but may be exposed. The steps of the mold may be formed on the second region II of the substrate 100.

Referring to FIGS. 11 to 3, a third insulating interlayer 340 may be formed on the CSP 240 to cover the mold and the exposed upper surface of the first support layer 300, and may be planarized until an upper surface of the uppermost one of the insulation layers 310 is exposed. Thus, a sidewall of the mold may be covered by the third insulating interlayer 340. A fourth insulating interlayer 350 may be formed on the mold and the third insulating interlayer 340.

An etching process may be performed to form a lower channel hole 360 through the fourth insulating interlayer 350, the mold, the first support layer 300 and the first sacrificial layer structure 290, which may extend in the first direction D1 and expose an upper surface of the CSP 240 on the first region I of the substrate 100. Additionally, a dummy channel hole 365 may be formed through the third and fourth insulating interlayers 340 and 350, a portion of the mold, the first support layer 300 and the first sacrificial layer structure 290 by an etching process, which may extend in the first direction D1 and expose the upper surface of the CSP 240 on the second region II of the substrate 100. In example embodiments, a plurality of lower channel holes 360 may be spaced apart from each other in the second and third directions D2 and D3 on the first region I of the substrate 100, and a plurality of dummy channel holes 365 may be spaced apart from each other in the second and third directions D2 and D3 on the second region II of the substrate 100.

The lower channel hole 360 and the dummy channel hole 365 may be formed simultaneously by one etching process, or sequentially formed by independent etching processes.

Referring to FIGS. 14 and 15, a lower charge storage structure layer and a lower channel layer may be formed on sidewalls of the lower channel hole 360 and the dummy channel hole 365, the exposed upper surface of the CSP 240 and an upper surface of the fourth insulating interlayer 350, and a lower filling layer may be formed on the lower channel layer to fill a remaining portion of each of the lower channel hole 360 and the dummy channel hole 365.

The lower charge storage structure layer may include a first lower blocking layer, a lower charge storage layer and a lower tunnel insulation layer sequentially stacked.

The lower filling layer, the lower channel layer and the lower charge storage structure layer may be planarized until the upper surface of the fourth insulating interlayer 350 is exposed. Thus, a lower charge storage structure 402, a lower channel 412 and a lower filling pattern 442 may be formed in the lower channel hole 360, and a dummy charge storage structure 404, a dummy channel 414 and a dummy filling pattern 444 may be formed in the dummy channel hole 365. The lower charge storage structure 402 may include a first lower blocking pattern 372, a lower charge storage pattern 382 and a lower tunnel insulation pattern 392 sequentially stacked, and the dummy charge storage structure 404 may include a dummy blocking pattern 374, a dummy charge storage pattern 384 and a dummy tunnel insulation pattern 394 sequentially stacked.

Upper portions of the lower filling pattern 442 and the lower channel 412 may be removed to form a second recess, upper portions of the dummy filling pattern 444 and the dummy channel 414 may be removed to form a third recess, and lower capping pattern 452 and a dummy capping pattern 454 may be formed to fill the second and third recesses, respectively.

The lower charge storage structure 402, the lower channel 412, the lower filling pattern 442 and the lower capping pattern 452 in the lower channel hole 360 may form a lower memory channel structure 462, and the dummy charge storage structure 404, the dummy channel 414, the dummy filling pattern 444 and the dummy capping pattern 454 may form a dummy memory channel structure 464. The dummy memory channel structure 464 may prevent the mold from collapsing, and thus may also be referred to as a support structure 464.

In example embodiments, each of the lower memory channel structure 462 and the support structure 464 may have a pillar shape extending in the first direction D1. In example embodiments, a plurality of lower memory channel structures 462 may be spaced apart from each other in the second and third directions D2 and D3 on the first region I of the substrate 100, and a plurality of support structures 464 may be spaced apart from each other in the second and third directions D2 and D3 on the second region II of the substrate 100.

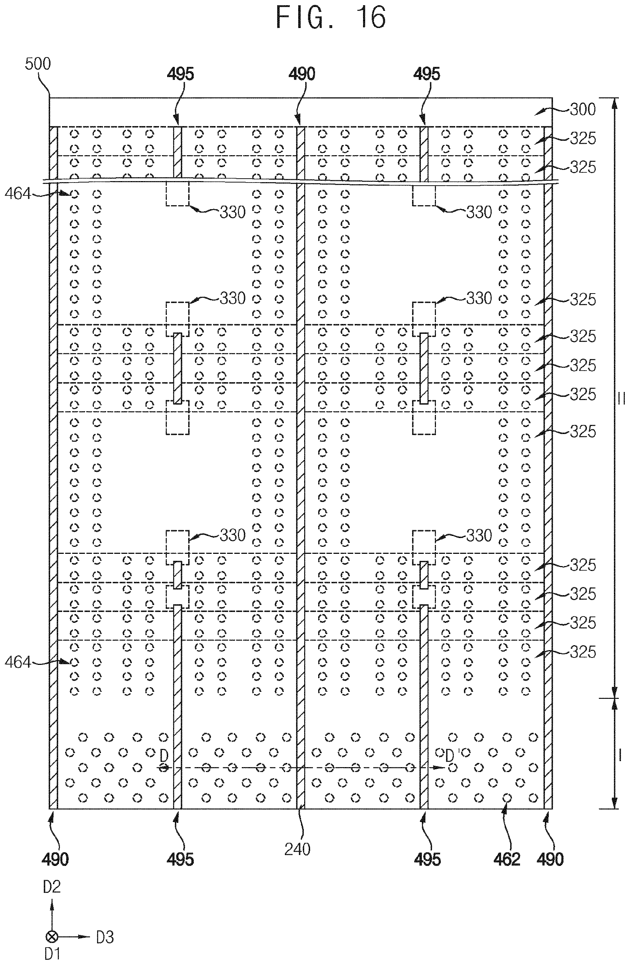

Referring to FIGS. 16 and 17, a fifth insulating interlayer 480 may be formed on the fourth insulating interlayer 350, the lower memory channel structure 462 and the support structure 464, and second and third openings 490 and 495 may be formed by an etching process through the third to fifth insulating interlayers 340, 350 and 480 and the mold.

In example embodiments, the second opening 490 may extend in the second direction D2 on the first and second regions I and II of the substrate 100 to each of opposite end portions in the second direction D2 of the mold, and a plurality of second openings 490 may be spaced apart from each other in the third direction D3. Thus, the mold may be divided into a plurality of parts spaced apart from each other in the third direction D3 by the second openings 490. As the second opening 490 is formed, the insulation layer 310 and the fourth sacrificial layer 320 included in the mold may be divided into first insulation patterns 315 and fourth sacrificial patterns 325, respectively, each of which may extend in the second direction D2.

In example embodiments, the third opening 495 may continuously extend in the second direction D2 on the first region I of the substrate 100, while a plurality of third openings 495 may be spaced apart from each other in the second direction D2 on the second region II of the substrate 100. The third openings 495 may be arranged in the second direction D2 between neighboring ones of the second openings 490 in the third direction D3. Unlike the second opening 490 continuously extending in the second direction D2 to the end portion in the second direction D2 of the mold, the third openings 495 are spaced apart from each other in the second direction D2, and thus the mold may not be entirely divided by the third opening 495. In example embodiments, a portion of the mold between neighboring ones of the third openings 495 in the second direction D2 may at least partially overlap the first division pattern 330 in the first direction D 1.

Even though the mold is divided into a plurality of parts, each of which may extend in the second direction D2, spaced apart from each other in the third direction D3 by the formation of the second and third openings 490 and 495, the mold may not collapse due to the support structures 464 and the lower memory channel structures 462.

In example embodiments, the etching process may be performed until the second and third openings 490 and 495 expose the upper surface of the CSP 240, and further, the second and third openings 490 and 495 may extend through an upper portion of the CSP 240.

A first spacer layer may be formed on sidewalls of the second and third openings 490 and 495 and an upper surface of the fifth insulating interlayer 480, and a portion of the first spacer layer on bottoms of the second and third openings 490 and 495 may be removed to form a first spacer 500, and thus an upper surface of the first support layer 300 may be partially exposed.

The exposed portion of the first support layer 300 and a portion of the first sacrificial layer structure 200 thereunder may be removed to enlarge the second and third openings 490 and 495 downwardly. Thus, each of the second and third openings 490 and 495 may expose an upper surface of the CSP 240, and may further extend through an upper portion of the CSP 240.

In example embodiments, the first spacer 500 may include or may be formed of, e.g., undoped polysilicon. When the first sacrificial layer structure 290 is partially removed, sidewalls of the second and third openings 490 and 495 may be covered by the first spacer 500, so that the first insulation patterns 315 and the fourth sacrificial patterns 325 included in the mold may not be removed.

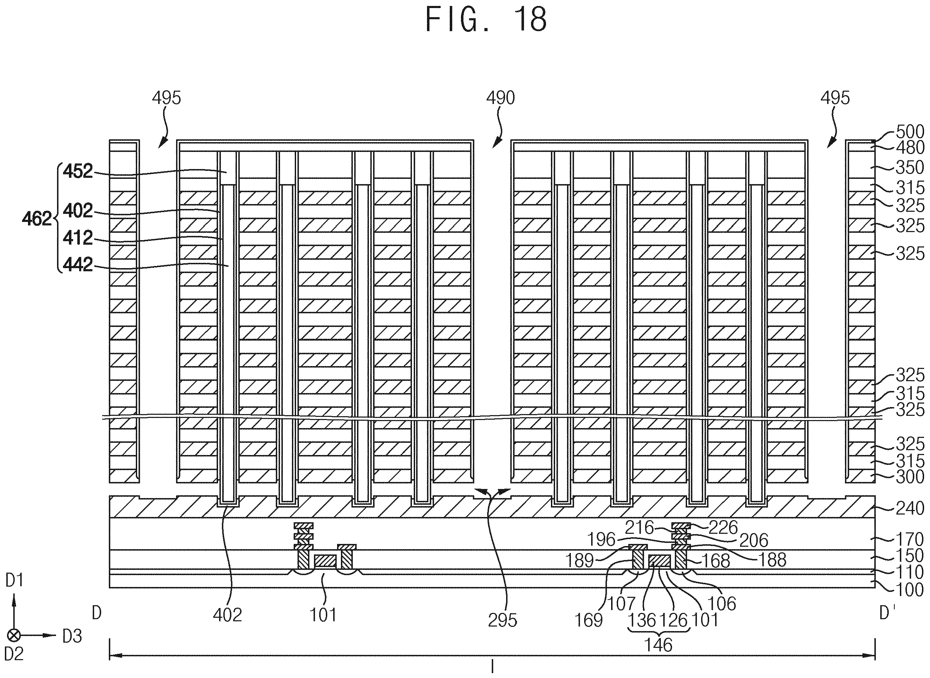

Referring to FIG. 18, the first sacrificial layer structure 290 may be removed through the second and third openings 490 and 495 by, e.g., a wet etching process, and thus a first gap 295 may be formed.

The wet etching process may be performed using, e.g., hydrofluoric acid (HF) and/or phosphoric acid (H₃PO₄). In example embodiments, each of the second and third openings 490 and 495 may not extend through the first support layer 300 and the first sacrificial layer structure 290, but may extend through the first support pattern 305 on the second region II of the substrate 100. Thus, the first sacrificial layer structure 290 may not be removed by the wet etching process on the second region II of the substrate 100.

As the first gap 295 is formed, a lower surface of the first support layer 300 and the upper surface of the CSP 240 may be exposed. Additionally, a sidewall of a portion of the lower charge storage structure 402 on the first region I of the substrate 100 may be removed by the first gap 295, and the portion of the lower charge storage structure 402 may also be removed to expose an outer sidewall of the lower channel 412. Thus, the lower charge storage structure 402 may be divided into an upper portion extending through the mold and covering an outer sidewall of a most portion of the lower channel 412 and a lower portion covering a lower surface of the lower channel 412 on the CSP 240.

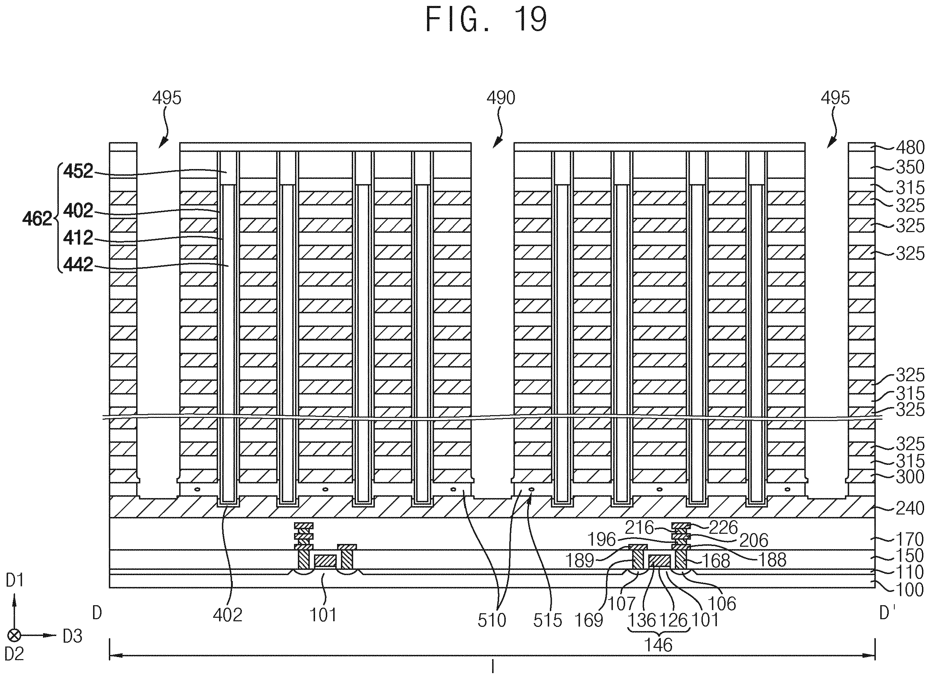

Referring to FIG. 19, the first spacer 500 may be removed, and a channel connection layer may be formed on the sidewalls of the second and third openings 490 and 495 and in the first gap 295, and a portion of the channel connection layer in the second and third openings 490 and 495 may be removed by, e.g., an etch back process to form a channel connection pattern 510 in the first gap 295.

As the channel connection pattern 510 is formed, the lower channels 412 between neighboring ones of the second and third openings 490 and 495 in the third direction D3 may be connected with each other.

An air gap 515 may be formed in the channel connection pattern 510.

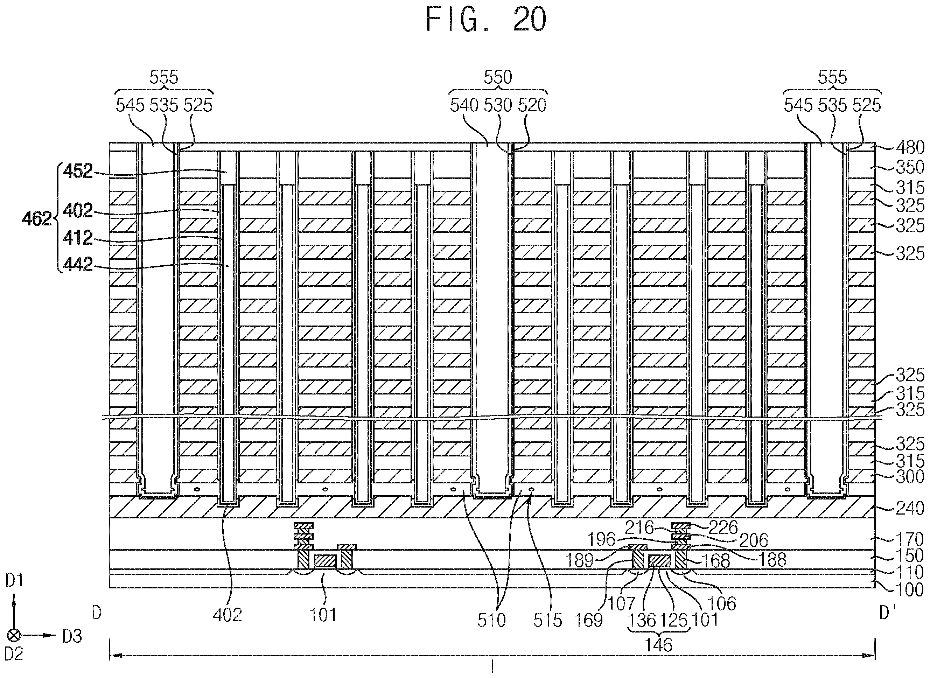

Referring to FIG. 20, second and third sacrificial layer structures 550 and 555 may be formed to fill the second and third openings 490 and 495, respectively.

The second and third sacrificial layer structures 550 and 555 may be formed by sequentially forming a first etch stop layer and a second spacer layer on the sidewalls of the second and third openings 490 and 495 and the exposed upper surface of the CSP 240, forming a fifth sacrificial layer on the second spacer layer to fill the second and third openings 490 and 495, and planarizing the fifth sacrificial layer, the second spacer layer and the first etch stop layer until the upper surface of the fifth insulating interlayer 480 is exposed.

The second sacrificial layer structure 550 may include a first etch stop pattern 520, a second spacer 530 and a fifth sacrificial pattern 540 sequentially stacked, and the third sacrificial layer structure 555 may include a second etch stop pattern 525, a third spacer 535 and a sixth sacrificial pattern 545 sequentially stacked.

The first etch stop layer may include or may be formed of a material having etching selectivity with respect to the fourth sacrificial pattern 325, e.g., an oxide such as silicon oxide. The second spacer layer may include or may be formed of a nitride, e.g., silicon nitride, and the fifth sacrificial layer may include or may be formed of a material having etching selectivity with respect to silicon oxide and silicon nitride, e.g., silicon oxycarbide.

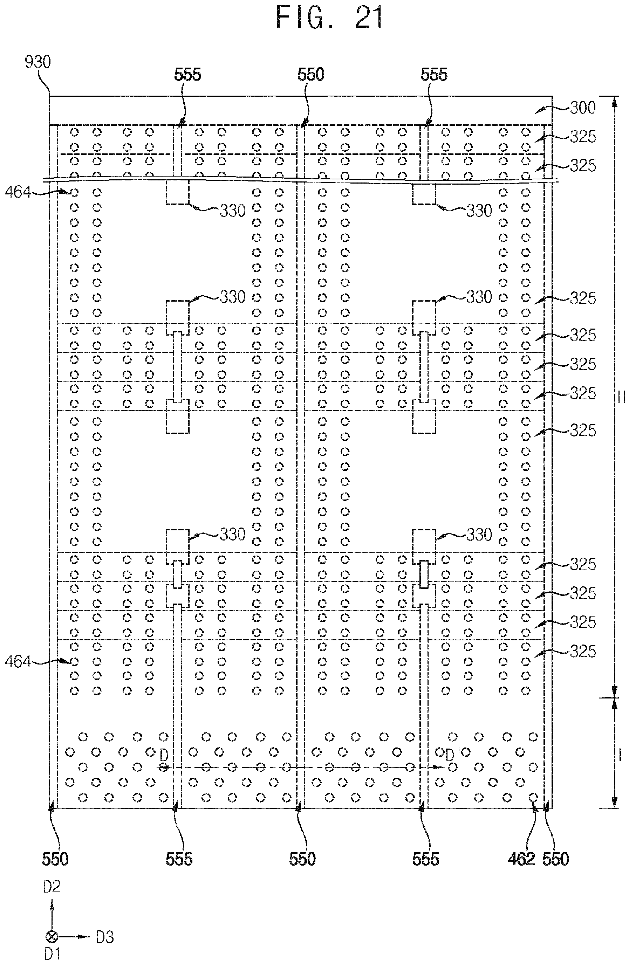

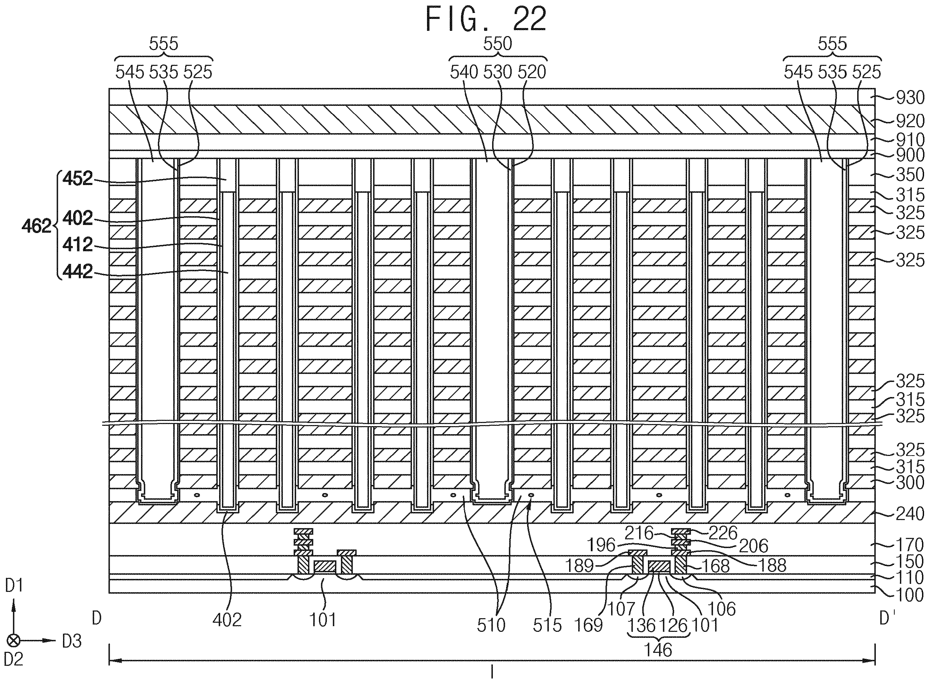

Referring to FIGS. 21 and 22, a planarization process may be performed on the fifth insulating interlayer 480 and the second and third sacrificial layer structures 550 and 555 until upper surfaces of the lower memory channel structure 462, the support structure 464 and the fourth insulating interlayer 350 are exposed.

The planarization process may include, e.g., a chemical mechanical polishing (CMP) process and/or an etch back process. As the planarization process is performed, upper surfaces of the lower capping pattern 452 and the dummy capping pattern 454 included in the lower memory channel structure 462 and the support structure 464, respectively, may be exposed.

A sixth insulating interlayer 900, a third etch stop layer 910, a second support layer 920 and a mask layer 930 may be sequentially stacked on the lower memory channel structure 462, the support structure 464, the second and third sacrificial layer structures 550 and 555 and the fourth insulating interlayer 350.

The sixth insulating interlayer 900 may include or may be formed of a nitride, e.g., silicon nitride, the third etch stop layer 910 may include or may be formed of an oxide, e.g., silicon oxide, the second support layer 920 may include or may be formed of, e.g., polysilicon doped with n-type impurities, and the mask layer 930 may include or may be formed of an oxide, e.g., silicon oxide.

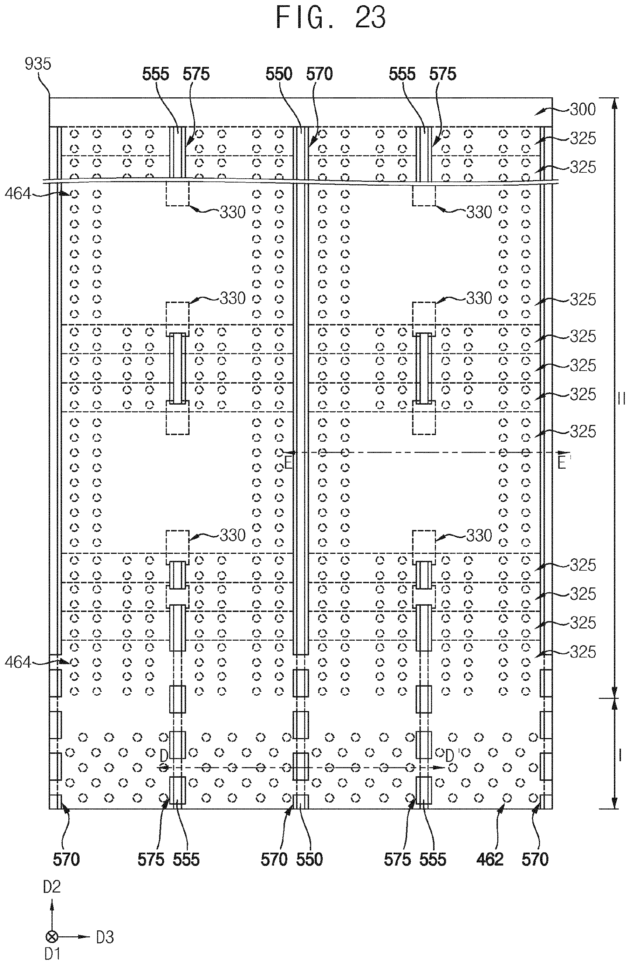

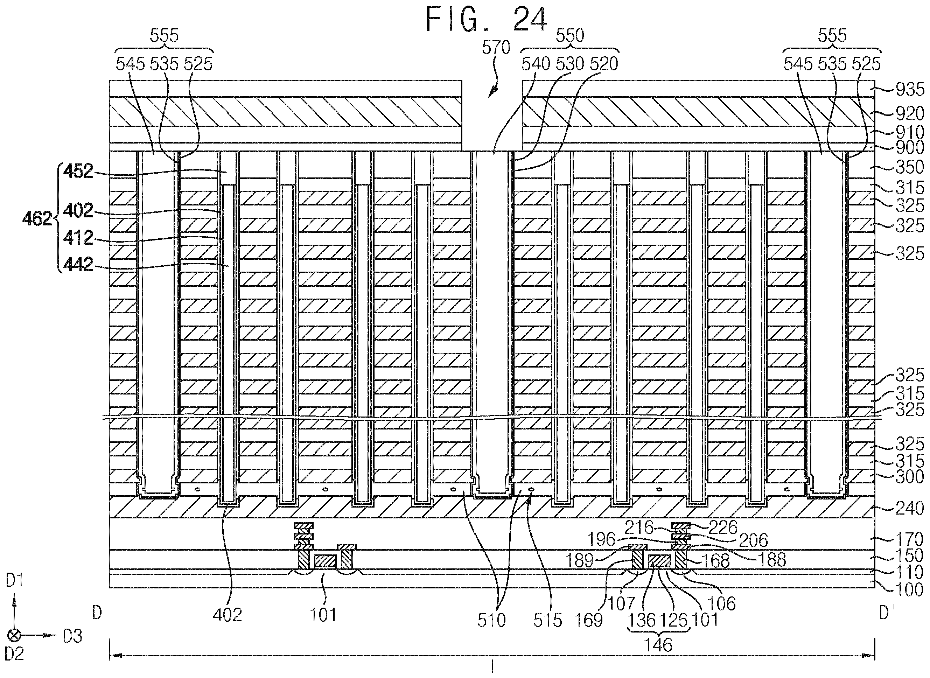

Referring to FIGS. 23 and 24, the mask layer 930 may be patterned to form a mask 935, and the second support layer 920, the third etch stop layer 910 and the sixth insulating interlayer 900 may be etched using the mask 935 as an etching mask to form fourth and fifth openings 570 and 575.

In example embodiments, the fourth opening 570 may overlap the second sacrificial layer structure 550 in the first direction D1. FIG. 23 shows that the fourth opening 570 continuously extend in the second direction D2 on the second region II of the substrate 100, and that a plurality of fourth openings 570 is spaced apart from each other in the second direction D2 on the second sacrificial layer structure 550 on the first region I of the substrate 100, however, the inventive concept may not be limited thereto, and thus, for example, a plurality of fourth openings 570 may be spaced apart from each other in the second direction D2 on the second region II of the substrate 100. In an example embodiment, a width in the third direction D3 of the fourth opening 570 may be greater than a width in the third direction D3 of the second sacrificial layer structure 550, however, the inventive concept may not be limited thereto.

In example embodiments, the fifth opening 575 may overlap the third sacrificial layer structure 555 in the first direction D1. Thus, a plurality of fifth openings 575 may be spaced apart from each other in the second direction D2 on the second region II of the substrate 100. Additionally, a plurality of fifth openings 575 may be spaced apart from each other in the second direction D2 on the third sacrificial layer structure 555 on the first region I of the substrate 100. In an example embodiment, a width in the third direction D3 of the fifth opening 575 may be greater than a width in the third direction D3 of the third sacrificial layer structure 555, however, the inventive concept may not be limited thereto.

In example embodiments, the fourth and fifth openings 570 and 575 may be arranged in a zigzag pattern on the first region I of the substrate 100. For example, the zigzag pattern may be formed along a straight line extending the third direction D3. The fourth and fifth openings 570 and 575 may partially overlap each other in the third direction D3.

The mask 935 may be removed, and thus an upper surface of the second support layer 920 may be exposed.

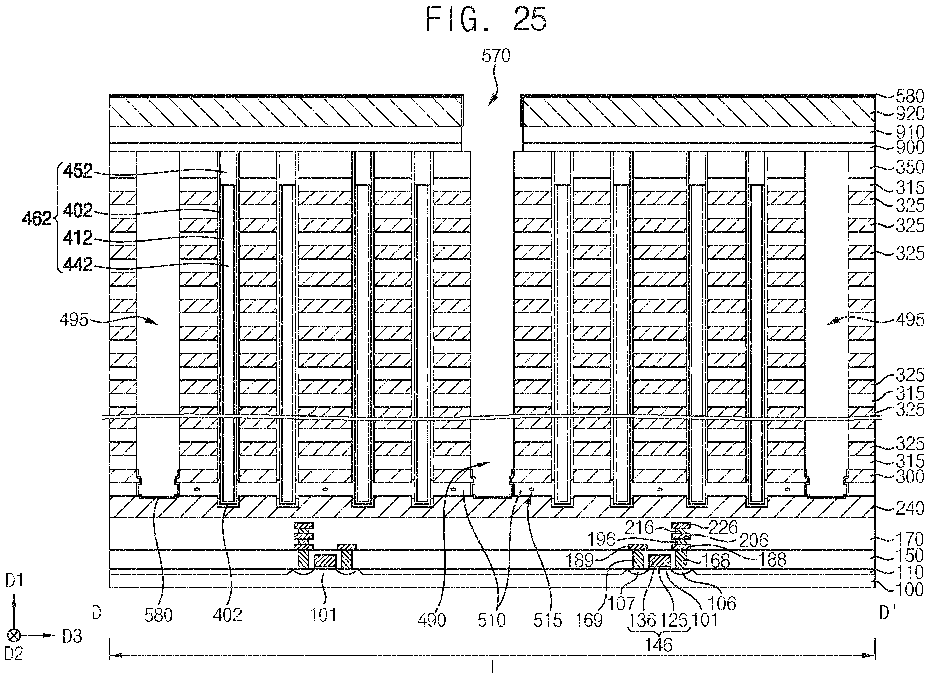

Referring to FIG. 25, an etching process may be performed through the fourth and fifth openings 570 and 575 to remove the second and third sacrificial layer structures 550 and 555, and thus the second and third openings 490 and 495 may be formed.

As illustrated above, the fourth and fifth openings 570 and 575 may not entirely expose but may partially cover the second and third sacrificial layer structures 550 and 555 on the first region I of the substrate 100, and thus, even though the second and third openings 490 and 495 are formed by the etching process, upper surfaces of the second and third sacrificial layer structures 550 and 555 may be at least partially covered by the sixth insulating interlayer 900, the third etch stop layer 910 and the second support layer 920. Thus, the mold may not collapse or fall down in the third direction D3. Additionally, the third openings 495 may be spaced apart from each other in the second direction D2 so that the mold may remain on the second region II of the substrate 100, and the support structure 464 may extend through the mold. Accordingly, the mold may not collapse or fall down in the third direction D3 by the mold and the support structure 464.

In example embodiments the second and third sacrificial layer structures 550 and 555 may be removed by, e.g., a wet etching process.

An oxidation process may be performed on a layer structure exposed by the second and third openings 490 and 495 and including silicon to form a protection layer 580 including silicon oxide. In example embodiments, as the oxidation process is performed, a protection layer 580 may be formed on the upper surface of the CSP 240, a sidewall of the channel connection pattern 510, a sidewall of the first support layer 300 and a sidewall of the first support pattern 305 exposed by the second and third openings 490 and 495, a sidewall of the second support layer 920 exposed by the fourth and fifth openings 570 and 575, and an upper surface of the second support layer 920.

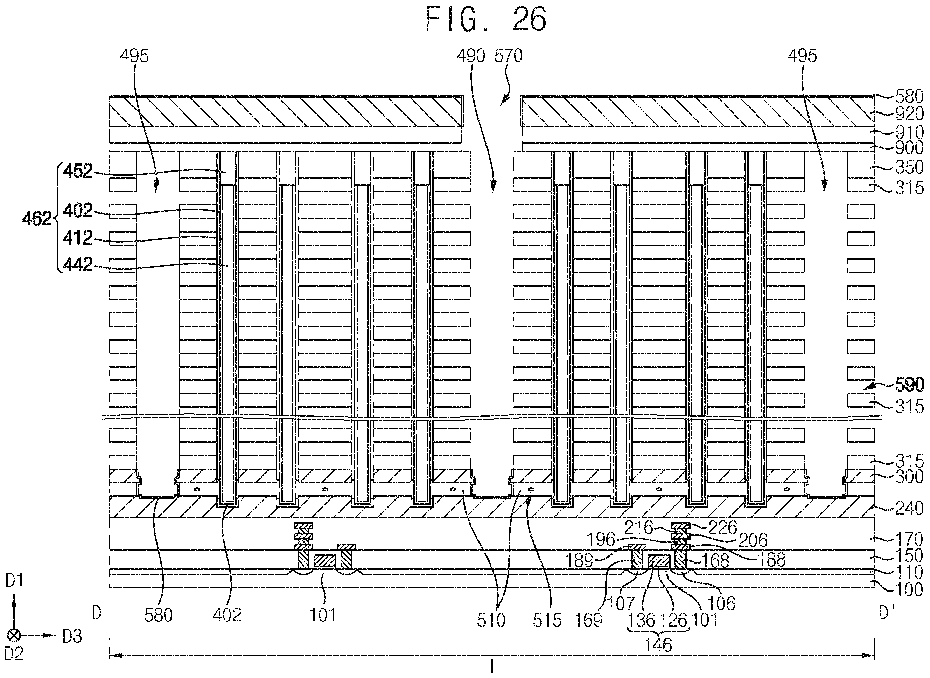

Referring to FIGS. 26 and 27, the fourth sacrificial patterns 325 may be removed by the second and third openings 490 and 495 to form a second gap 590 between neighboring ones of the first insulation patterns 315 in the first direction D 1, and a portion of an outer sidewall of the lower charge storage structure 402 included in the lower memory channel structure 462 and a portion of an outer sidewall of the dummy charge storage structure 404 included in the support structure 464 may be exposed by the second gap 590.

In example embodiments, a wet etching process may be performed using, e.g., phosphoric acid (H₃PO₄) or sulfuric acid (H₂SO₄) to remove the fourth sacrificial patterns 325.

The wet etching process may be performed through the second and third openings 490 and 495, and an entire portion of the fourth sacrificial pattern 325 between the second and third openings 490 and 495 may be removed by an etching solution provided from the second and third openings 490 and 495 in both directions.

However, in an area where the third opening 495 is not formed between the second openings 490 on the second region II of the substrate 100, the etching solution may be provided from the second opening 490 in a single direction, and thus a portion of the fourth sacrificial pattern 325 may not be removed but remain, which may be referred to as a third insulation pattern 327. Additionally, a portion of the first insulation pattern 315 overlapping the third insulation pattern 327 in the first direction D1 may be referred to as a second insulation pattern 317. The second and third insulation patterns 317 and 327 alternately and repeatedly stacked in the first direction D1 may form an insulation pattern structure 600.

The insulation pattern structure 600 may extend through a portion of the mold on the second region II of the substrate 100, and may have a shape of, e.g., a rectangle, an ellipse, a circle, etc., in a plan view. In example embodiments, the insulation pattern structure 600 may extend through the second step of the mold having a relatively large length in the second direction D2.

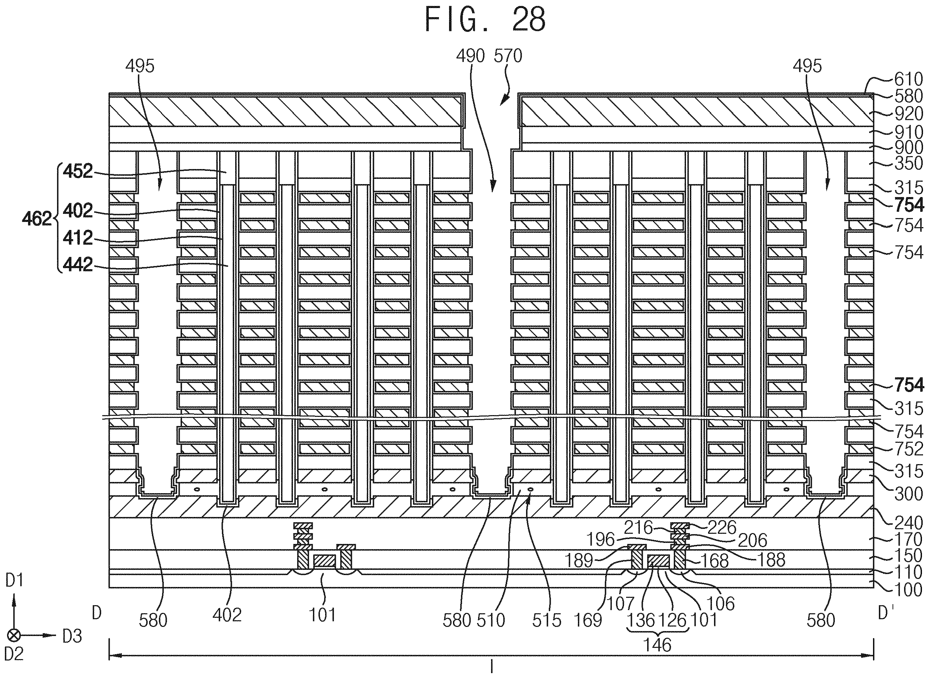

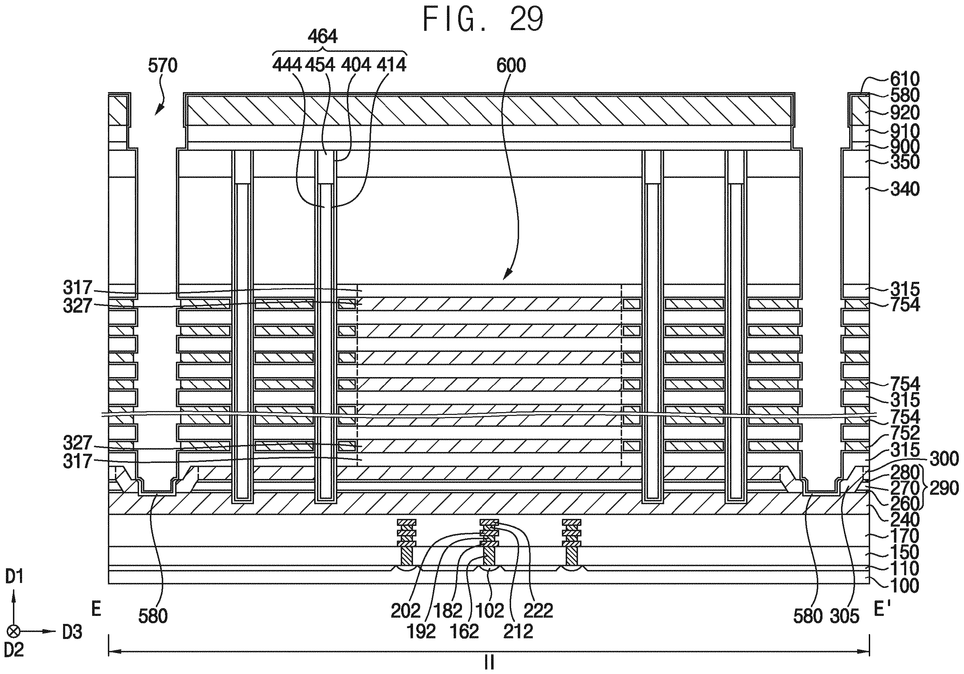

Referring to FIGS. 28 and 29, a second lower blocking layer 610 may be formed on the first insulation pattern 315, the third, fourth and sixth insulating interlayers 340, 350 and 900 and a sidewall of the third etch stop layer 910 exposed by the second to fifth openings 490, 495, 570 and 575, an inner wall of the second gap 590, the outer sidewalls of the lower charge storage structure 402 and the dummy charge storage structure 404 exposed by the second gap 590, and a sidewall and an upper surface of the protection layer 580, and a gate electrode layer may be formed on the second lower blocking layer 610.

The gate electrode layer may include a gate barrier layer and a gate conductive layer sequentially stacked.

The gate electrode layer may be partially removed to form a gate electrode in each of the second gaps 590. In example embodiments, the gate electrode layer may be partially removed by a wet etching process. As a result, the fourth sacrificial pattern 325 in the mold including the step layers of the fourth sacrificial pattern 325 and the first insulation pattern 315 may be replaced with the gate electrode and the second lower blocking layer 610 covering lower and upper surfaces of the gate electrode.

In example embodiments, the gate electrode may extend in the second direction D2, and a plurality of gate electrodes may be spaced apart from each other in the first direction D1 to form a preliminary gate electrode structure. The preliminary gate electrode structure may have a staircase shape including the gate electrode as a step layer. An end portion of each of the gate electrodes in the second direction D2 that is not overlapped by ones of the gate electrodes overlying each of the gate electrodes may be referred to as a pad. The gate electrode structure may include first pads having a relatively small length in the second direction D2 and second pads having a relatively large length in the second direction D2, and the numbers of the first and second pads may not be limited.

In example embodiments, a plurality of preliminary gate electrode structures may be spaced apart from each other in the third direction D3, which may be separated by the second openings 490 in the third direction D3. As illustrated above, the third openings 495 may be spaced apart from each other in the second direction D2, and thus the preliminary gate electrode structure may not be entirely divided by the third openings 495. However, one of the gate electrodes at a lowermost level in the preliminary gate electrode structure may be divided in the third direction D3 by the third openings 495, the first division pattern 330 and the insulation pattern structure 600.

The preliminary gate electrode structure may include a first gate electrode 752 at a lowermost level, and second gate electrodes 754 at a plurality of levels, respectively, on the first gate electrode 752. In example embodiments, the first gate electrode 752 may serve as a ground selection line (GSL), and the second gate electrode 754 may serve as a word line.

In example embodiments, a lower memory block including the first gate electrodes 752 and 754, the lower charge storage structures 402 and the lower channels 412 between neighboring ones of the second openings 490 in the third direction D3 may include two GSLs at each level and one word line at each level, however, the inventive concept may not be limited thereto.

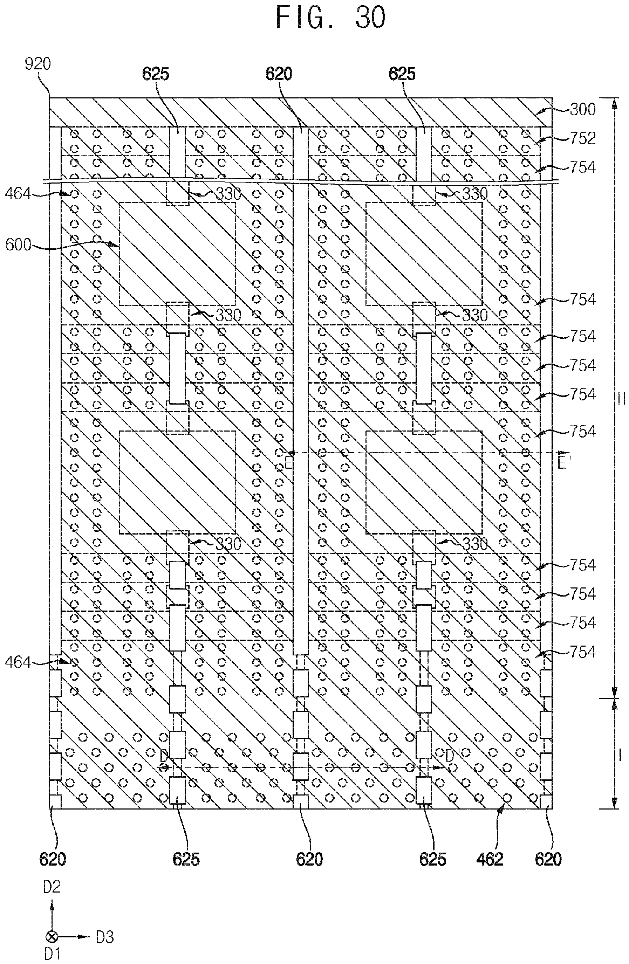

Referring to FIGS. 30 to 32, a second division pattern 620 filling the second and fourth openings 490 and 570 and a third division pattern 625 filling the third and fifth openings 495 and 575 may be formed on the second lower blocking layer 610, and the second and third division patterns 620 and 625 may be planarized until an upper surface of the second support layer 920 is exposed. Thus, the second lower blocking layer 610 may be transformed into a second lower blocking pattern 615, and a portion of the protection layer 580 on the second support layer 920 may be removed.

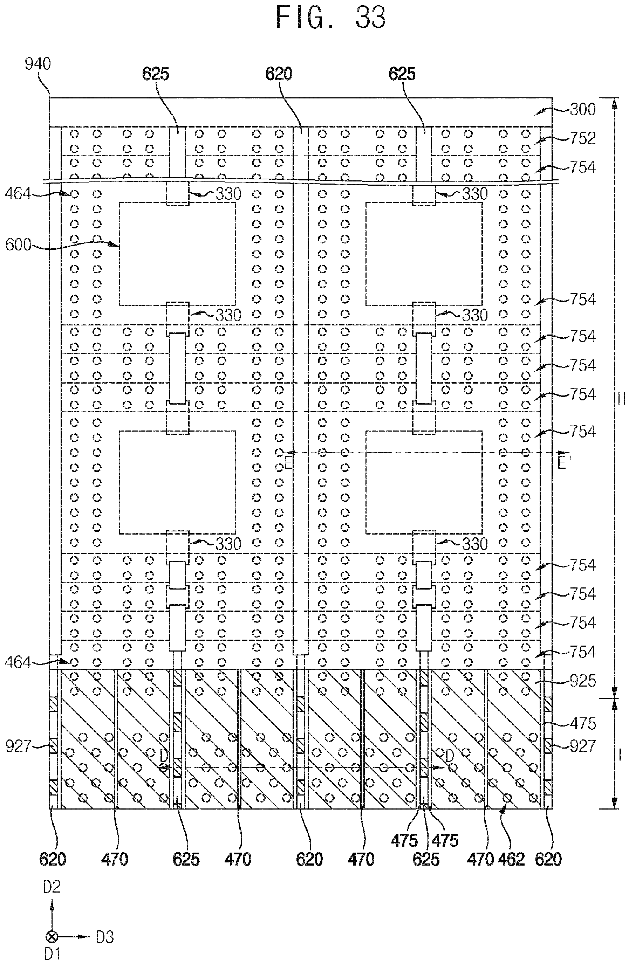

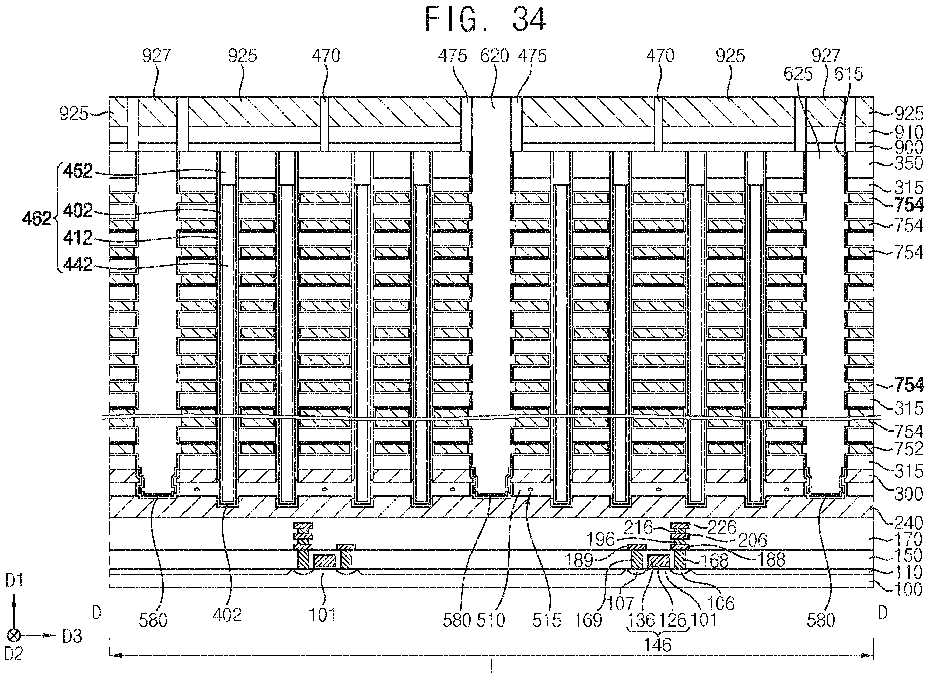

Referring to FIGS. 33 and 34, portions of the second support layer 920, the third etch stop layer 910 and the sixth insulating interlayer 900 on the second region II of the substrate 100 except for a portion of the second region II adjacent to the first region I of the substrate 100 may be removed to form a sixth opening exposing an upper surface of the fourth insulating interlayer 350 is exposed, and thus the second support layer 920 may be transformed into a second support pattern 925.

Additionally, a seventh opening extending through the portions of the second support pattern 925, the third etch stop layer 910 and the sixth insulating interlayer 900 remaining on the first region I and the portion of the second region II adjacent to the first region I of the substrate 100 to expose the upper surface of the fourth insulating interlayer 350, and an eighth opening extending through upper portions of the second and third division patterns 620 and 625 and the portions of the second support pattern 925, the third etch stop layer 910 and the sixth insulating interlayer 900 on the first region I and the portion of the second region II adjacent to the first region I of the substrate 100 to expose the upper surface of the fourth insulating interlayer 350 may be formed.

In example embodiments, the seventh opening may be formed between the second and third division patterns 620 and 625, e.g., at a central portion in the third direction D3 between neighboring ones of the second and third division patterns 620 and 625, and may extend in the second direction D2 on the first region I and the portion of the second region II adjacent to the first region I of the substrate 100.

In example embodiments, the eighth opening may be formed by removing each of opposite lateral portions in the third direction D3 of the upper portion of each of the second and third division patterns 620 and 625 and portions of the second support pattern 925, the third etch stop layer 910 and the sixth insulating interlayer 900 adjacent thereto so as to extend in the second direction D2 on the first region I and the portion of the second region II adjacent to the first region I of the substrate 100. During the formation of the eighth opening, portions of the second lower blocking pattern 615 and the protection layer 580 on the sidewall of the second support pattern 925 may also be removed.

As the sixth to eighth openings are formed, a plurality of second support patterns 925, each of which may extend in the second direction D2, may be spaced apart from each other in the third direction D3 on the first region I and the portion of the second region II adjacent to the first region I of the substrate 100, and a plurality of third support patterns 927 may be spaced apart from each other in the second direction D2 between the eighth openings at opposite sides, respectively, in the third direction D3 of each of the second and third division patterns 620 and 625.

Each of the second support patterns 925 may also serve as a string selection line (SSL), and thus may also be referred to as a third gate electrode 925. The preliminary gate electrode structure including the first and second gate electrodes 752 and 754 and the third gate electrode 925 may collectively form a gate electrode structure.

In example embodiments, a length in the second direction D2 of the third gate electrode 925 may be less than a length in the second direction D2 of an uppermost one of the second gate electrodes 754. Thus, an end portion in the second direction D2 of the uppermost one of the second gate electrodes 754 may not be overlapped by the third gate electrode 925 in the first direction D1, and the gate electrode structure may have a staircase shape. An end portion in the second direction D2 of the third gate electrode 925 may also be referred to as a pad.

A seventh insulating interlayer 940 filling the sixth opening, and fourth and fifth division patterns 470 and 475 filling the seventh and eighth openings may be formed.

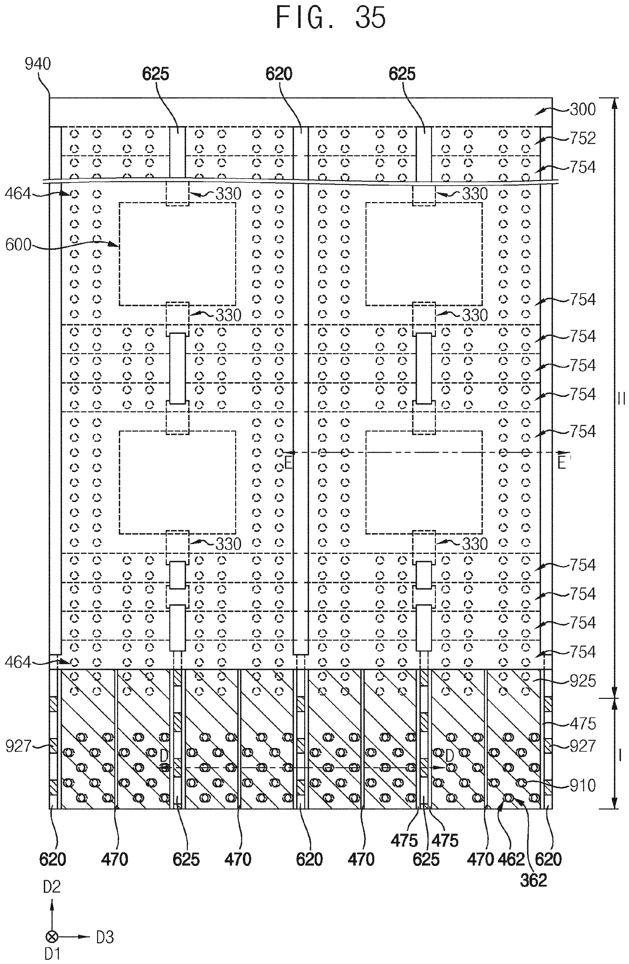

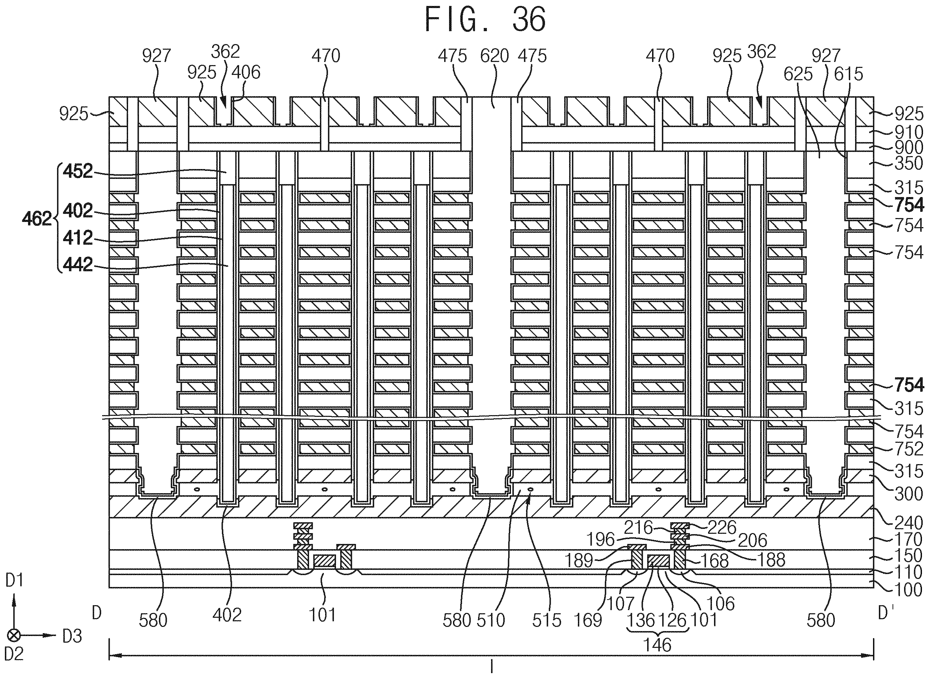

Referring to FIGS. 35 and 36, a preliminary upper channel hole 362 may be formed through the third gate electrode 925 to expose an upper surface of the third etch stop layer 910.

In example embodiments, a plurality of preliminary upper channel holes 362 may be spaced apart from each other in the second and third directions D2 and D3, and each of the preliminary upper channel holes 362 may partially overlap the lower memory channel structure 462 in the first direction D1.

An upper charge storage layer structure may be formed on a sidewall and a bottom of the preliminary upper channel hole 362, the third gate electrode 925, the second to fifth division patterns 620, 625, 470 and 475 and the seventh insulating interlayer 940, and may be partially etched by an etch back process to form an upper charge storage structure 406 on the sidewall and an edge portion of the bottom of the preliminary upper channel hole 362. The upper charge storage structure 406 may include a first upper blocking pattern, an upper charge storage pattern and an upper tunnel insulation pattern sequentially stacked on the sidewall of the preliminary upper channel hole 362.

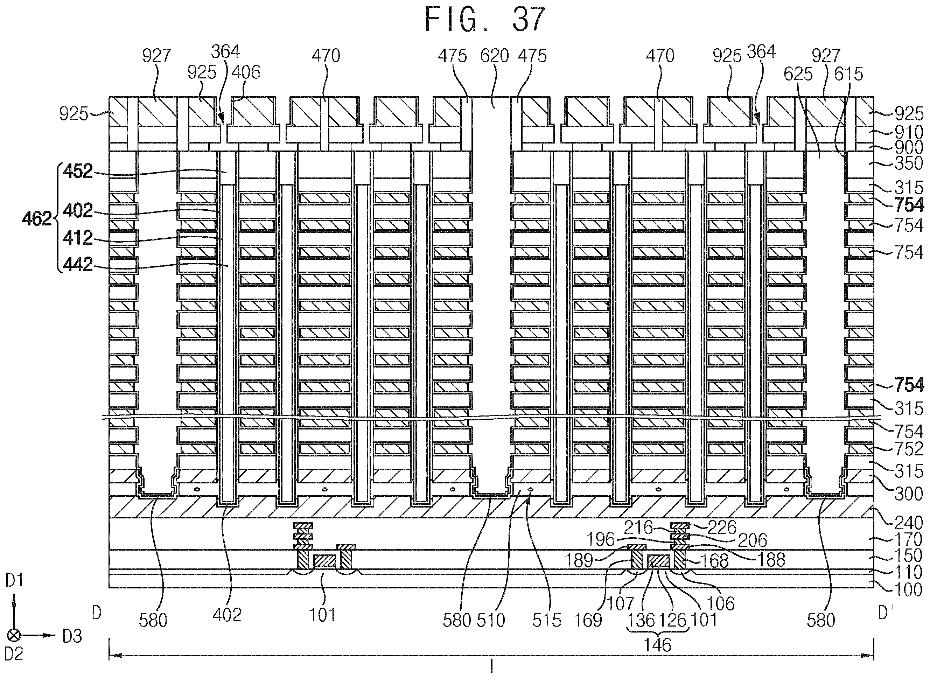

Referring to FIG. 37, a portion of the third etch stop layer 910 not covered by the upper charge storage structure 406 and a portion of the sixth insulating interlayer 900 thereunder may be removed to enlarge the preliminary upper channel hole 362 downwardly, and a portion of the sixth insulating interlayer 900 adjacent to the preliminary upper channel hole 362 may be additionally removed to enlarge the preliminary upper channel hole 362 in the horizontal direction, and thus an upper channel hole 364 exposing an upper surface of the lower memory channel structure 462 may be formed.

The upper channel hole 364 may also expose a portion of the fourth insulating interlayer 350 adjacent to the lower memory channel structure 462.

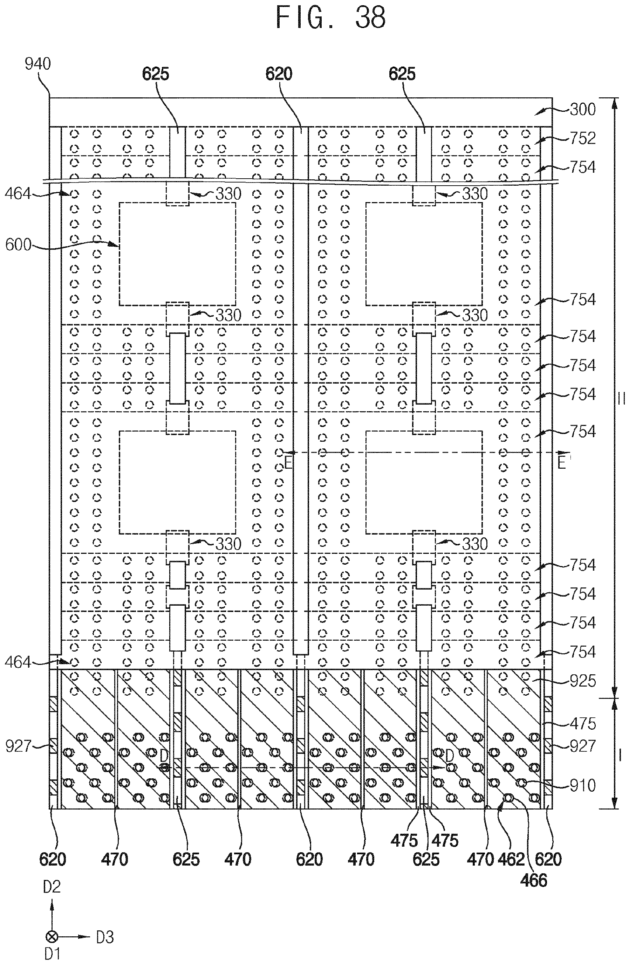

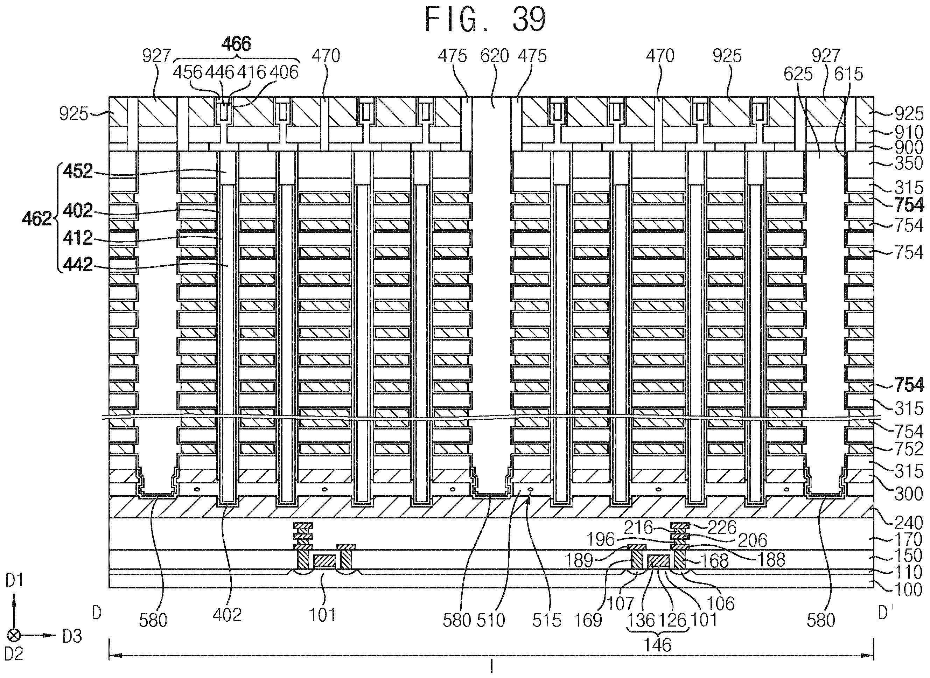

Referring to FIGS. 38 and 39, an upper channel 416, an upper filling pattern 446 and an upper capping pattern 456 may be formed in the upper channel hole 364.

In example embodiments, the upper channel 416 may be formed in a lower portion of the upper channel hole 364 surrounded by the sixth insulating interlayer 900 and the third etch stop layer 910 and on a sidewall of the upper charge storage structure 406 in an upper portion of the upper channel hole 364. The upper filling pattern 446 may fill a space surrounded by the upper channel 416. The upper capping pattern 456 may be formed on the upper channel 416 and the upper filling pattern 446 in the upper portion of the upper channel hole 364, and may be surrounded by the upper charge storage structure 406.

The upper charge storage structure 406, the upper channel 416, the upper filling pattern 446 and the upper capping pattern 456 may collectively form an upper memory channel structure 466, and may be connected to the lower memory channel structure 462.

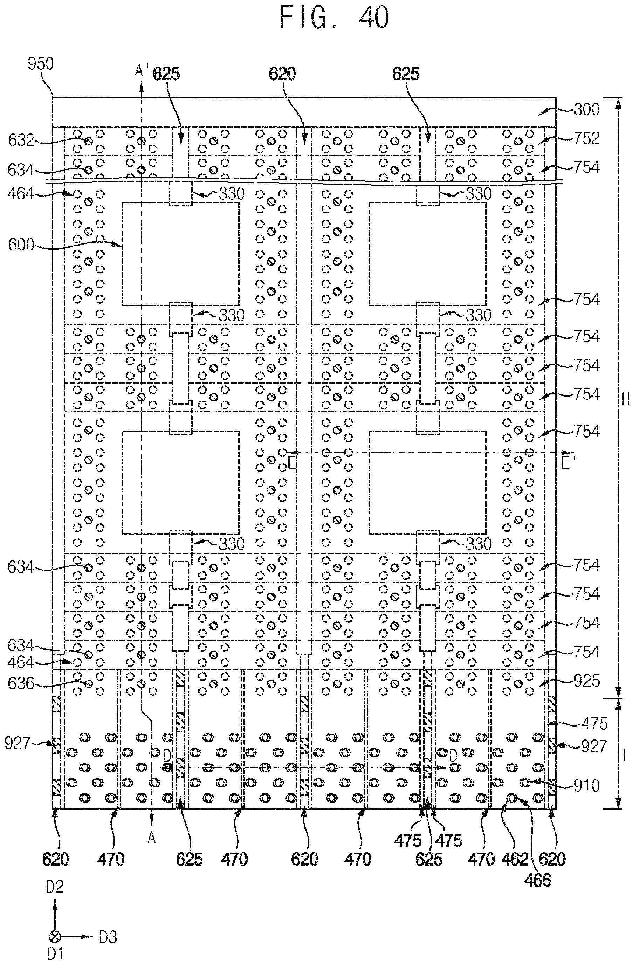

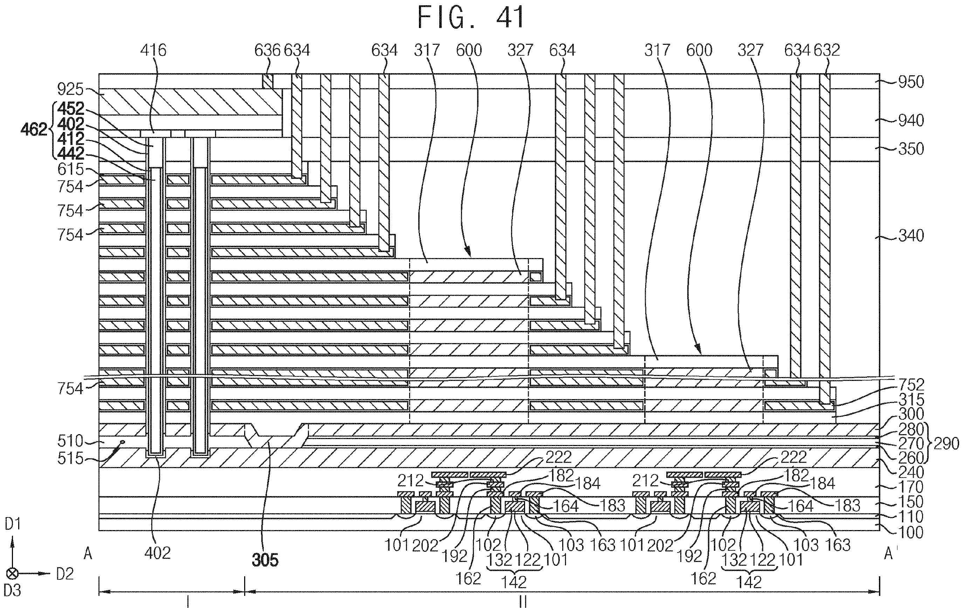

Referring to FIGS. 40 and 41, an eighth insulating interlayer 950 may be formed on the third gate electrode 925, the seventh insulating interlayer 940, the second to fifth division patterns 620, 625, 470 and 475, and the upper memory channel structure 466, and first and second upper contact plugs 632 and 634 extending through the third, fourth, seventh and eighth insulating interlayers 340, 350, 940 and 950 and the first insulation pattern 315, and a third upper contact plug 636 extending through the eighth insulating interlayer 950 may be formed on the second region II of the substrate 100.

The first to third upper contact plugs 632, 634 and 636 may contact upper surfaces of the pads of the first to third gate electrodes 752, 754 and 925, respectively. In example embodiments, each of the first to third upper contact plugs 632, 634 and 636 may be formed in an area surrounded by the support structures 464 at each pad of the gate electrode structure in a plan view. For example, the support structures 464 may be disposed at vertices of a rectangle, and each of the first to third upper contact plugs 632, 634 and 636 may be formed in an inside of the rectangle in a plan view.

FIG. 40 shows a layout of the first to third upper contact plugs 632, 634 and 636, however, the inventive concept may not be limited thereto.

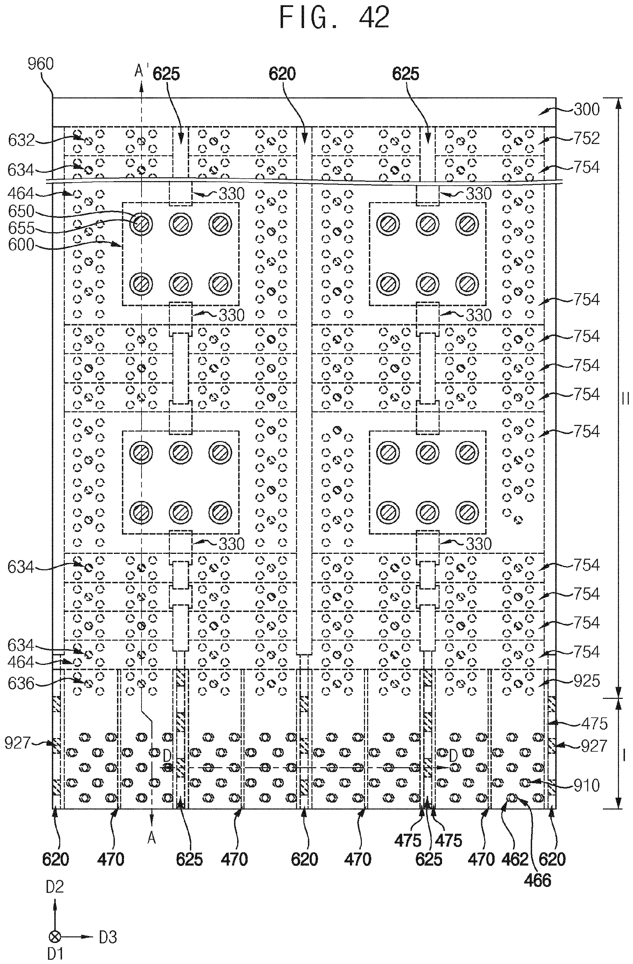

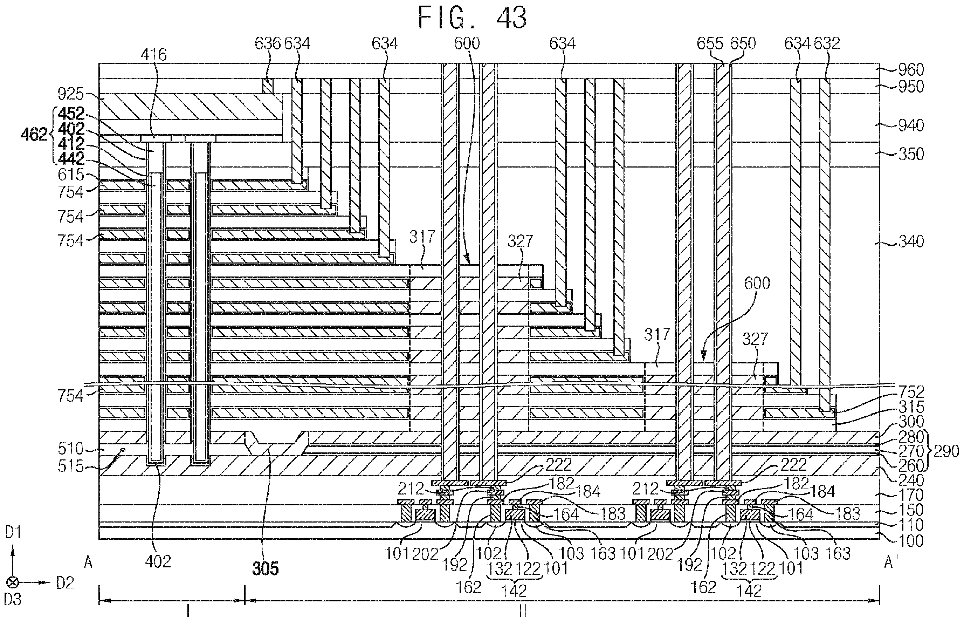

Referring to FIGS. 42 and 43, a ninth insulating interlayer 960 may be formed on the eighth insulating interlayer 950 and the first to third upper contact plugs 632, 634 and 636, and a through via 655 may be formed through the third, fourth, seventh, eighth and ninth insulating interlayers 340, 350, 940, 950 and 960, the insulation pattern structure 600, the first support layer 300, the first sacrificial layer structure 290, the CSP 240 and an upper portion of the second insulating interlayer 170 to contact an upper surface of the eighth lowering wiring 222 on the second region II of the substrate 100.

In example embodiments, a plurality of through vias 655 may be spaced apart from each other in an area where the insulation pattern structure 600 is formed. FIG. 42 shows sixth through vias 655 in each area, however, the inventive concept may not be limited thereto.

A fourth insulation pattern 650 may be formed on a sidewall of the through via 655, and thus the through via 655 may be electrically insulated from the first support layer 300 and the CSP 240. The through via 655 may extend through the insulation pattern structure 600, that is, the second and third insulation patterns 317 and 327 so as to be electrically insulated from the first and second gate electrodes 752 and 754, and thus, if an insulation pattern is formed on sidewalls of the first support layer 300 and the CSP 240, the fourth insulation pattern 650 may not be formed.

Referring to FIGS. 1 to 6, a tenth insulating interlayer 970 may be formed on the ninth insulating interlayer 960, the fourth insulation pattern 650 and the through via 655, and fourth to eighth upper contact plugs 682, 684, 686, 688 and 690 may be formed.

The fourth to sixth upper contact plugs 682, 684 and 686 may extend through the ninth and tenth insulating interlayers 960 and 970 to contact upper surfaces of the first to third upper contact plugs 632, 634 and 636, the seventh upper contact plug 688 may extend through the tenth insulating interlayer 970 to contact an upper surface of the through via 655, and the eighth upper contact plug 690 may extend through the eighth to tenth insulating interlayers 950, 960 and 970 to contact an upper surface of the upper memory channel structure 466.

An eleventh insulating interlayer 980 may be formed on the tenth insulating interlayer 970 and the fourth to eighth upper contact plugs 682, 684, 686, 688 and 690, and first to fifth upper wirings 712, 714, 716, 718 and 720 may be formed through the eleventh insulating interlayer 980.

The first to fifth upper wirings 712, 714, 716, 718 and 720 may contact upper surfaces of the fourth to eighth upper contact plugs 682, 684, 686, 688 and 690, respectively.

In example embodiments, the fifth upper wiring 720 may extend in the third direction D3, and a plurality of fifth upper wirings 720 may be spaced apart from each other in the second direction D2. The fifth upper wiring 720 may serve as a bit line of the semiconductor device. Alternatively, an upper via and a sixth upper wiring may be further formed on the fifth upper wiring 720, and the sixth upper wiring may serve as the bit line.

The first to fifth upper wirings 712, 714, 716, 718 and 720 may have various layouts on the second region II of the substrate 100.

The semiconductor device may be manufactured by the above processes.

As illustrated above, the sixth insulating interlayer 900, the third etch stop layer 910 and the second support layer 920 may be formed on the fourth insulating interlayer 350 and the lower memory channel structure 462, the fourth and fifth openings 570 and 575 may be formed through the sixth insulating interlayer 900, the third etch stop layer 910 and the second support layer 920 to expose the second and third sacrificial layer structures 550 and 555, and the exposed second and third sacrificial layer structures 550 and 555 may be removed to form the second and third openings 490 and 495.

The fourth and fifth openings 570 and 575 may extend through the sixth insulating interlayer 900, the third etch stop layer 910 and the second support layer 920, but may not continuously extend in the second direction D2, and thus, even though the second and third openings 490 and 495 are formed, the mold may not collapse.

The second support layer 920 may include or may be formed of a conductive material, e.g., doped polysilicon, and thus, may serve as a gate electrode as well as a support structure for supporting the mold. That is, the second support pattern 925, which may be formed by patterning the second support layer 920, together with the first and second gate electrodes 752 and 754 may form the gate electrode structure, and the second support pattern 925 may serve as an SSL.

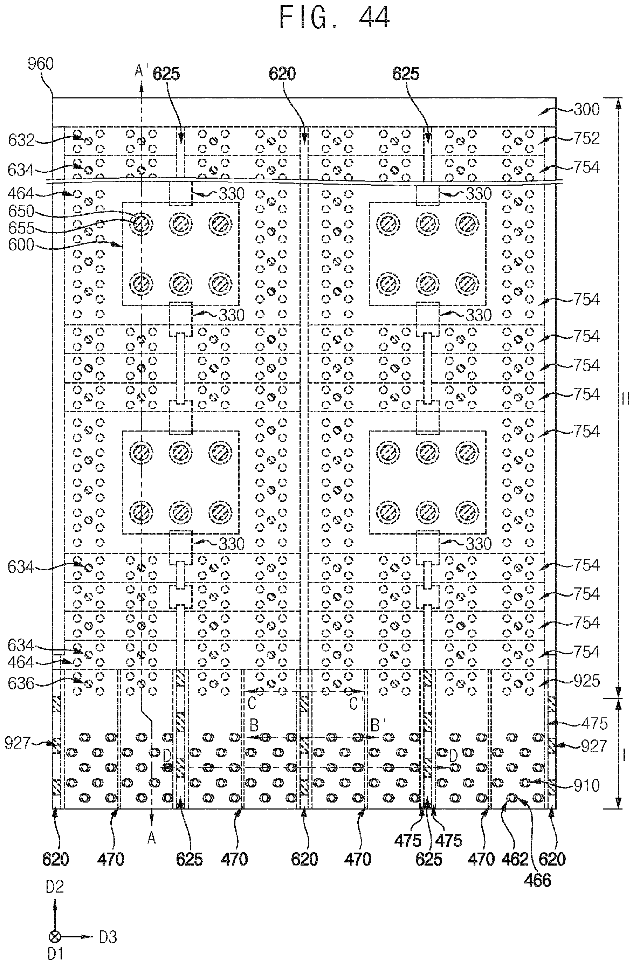

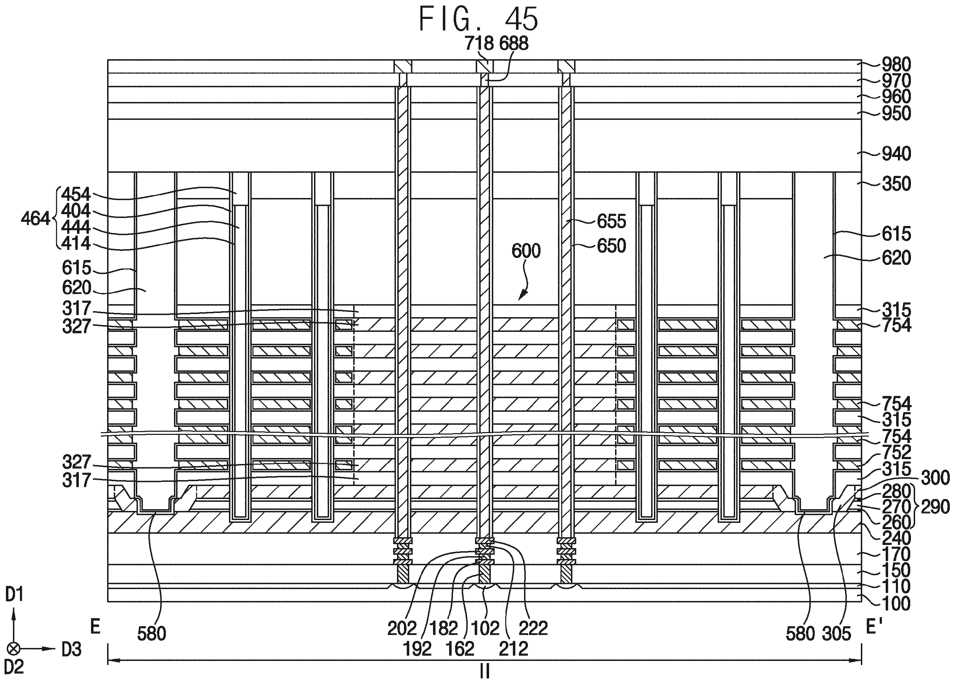

FIGS. 44 and 45 are a plan view and a cross-sectional view, respectively, illustrating a semiconductor device in accordance with example embodiments, which may correspond to FIGS. 2 and 6, respectively.

This semiconductor device may be substantially the same as or similar to that of FIGS. 1 to 6, except for the second and third division patterns 620 and 625.

Referring to FIGS. 44 and 45, upper surfaces of the second and third division patterns 620 and 625 on the second region II of the substrate 100 may be substantially coplanar with an upper surface of the fourth insulating interlayer 350.

That is, when the sixth opening is formed by removing the portions of the sixth insulating interlayer 900, the third etch stop layer 910 and the second support layer 920 on the second region II of the substrate 100 through the processes illustrated with reference to FIGS. 33 and 34, upper portions of the second and third division patterns 620 and 625 on the second region II of the substrate 100 may also be removed, and thus the upper surfaces of the second and third division patterns 620 and 625 may be substantially coplanar with the upper surface of the fourth insulating interlayer 350.

Accordingly, the upper portions of the second and third division patterns 620 and 625 having relatively large widths may be removed on the second region II of the substrate 100 except for the portion of the second region II adjacent to the first region I of the substrate 100, and the lower portions of the second and third division patterns 620 and 625 having relatively small widths may remain.

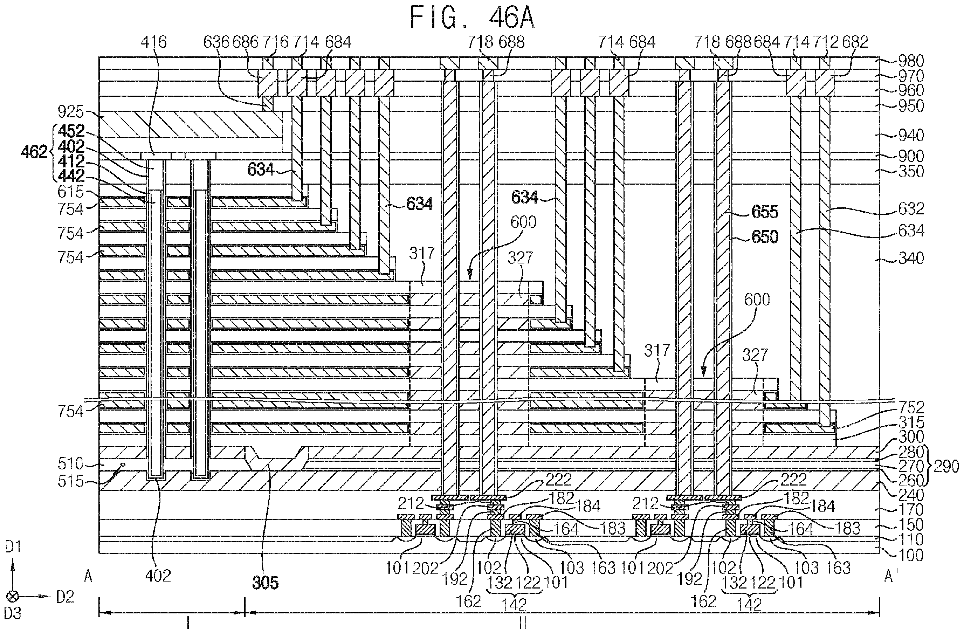

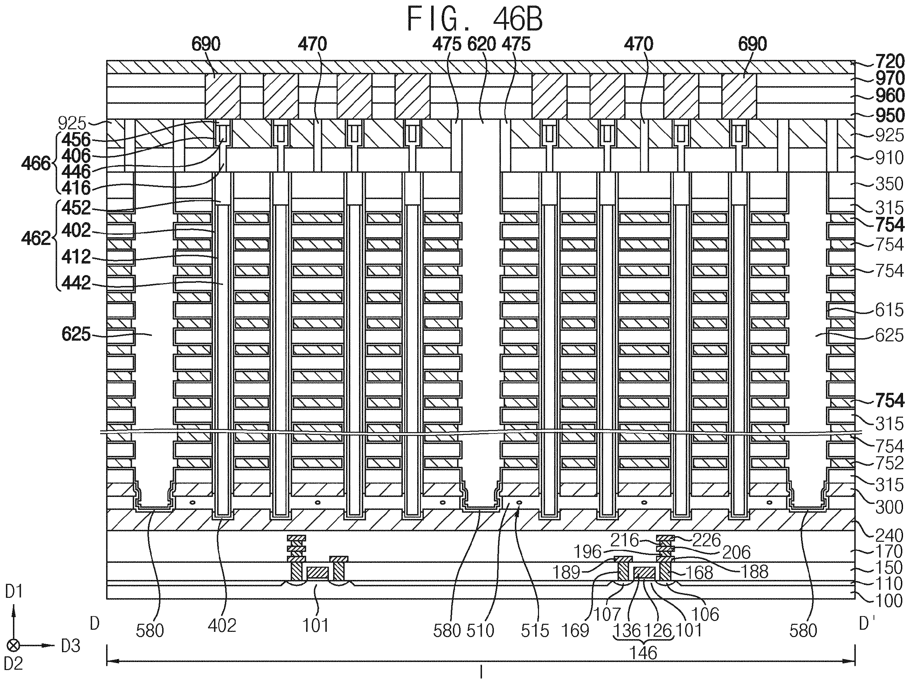

FIGS. 46A and 46B are cross-sectional views illustrating semiconductor devices in accordance with example embodiments, which may correspond to FIGS. 3 and 5, respectively.

This semiconductor device may be substantially the same as or similar to that of FIGS. 1 to 6, except for some elements.

Referring to FIG. 46A, the sixth insulating interlayer 900 may remain between the fourth insulating interlayer 350 and the seventh insulating interlayer 940 on the second region II of the substrate 100.

That is, when the sixth opening is formed by removing the portions of the third etch stop layer 910 and the second support layer 920 on the second region II of the substrate 100 through the processes illustrated with reference to FIGS. 33 and 34, the portion of the sixth insulating interlayer 900 on the second region II of the substrate 100 may not be removed, and thus the sixth insulating interlayer 900 may remain on the second region II of the substrate 100 as well as on the first region I of the substrate 100.

Referring to FIG. 46B, the sixth insulating interlayer 900 may not be formed between the fourth insulating interlayer 350 and the third etch stop layer 910 on the first region I of the substrate 100 and the portion of the second region II adjacent to the first region I of the substrate 100.

That is, when the processes illustrated with reference to FIGS. 21 and 22 are performed, after planarizing the fifth insulating interlayer 480 and the second and third sacrificial layer structures 550 and 555 until the upper surfaces of the lower memory channel structure 462, the support structure 464 and the fourth insulating interlayer 350 are exposed, the third etch stop layer 910, the second support layer 920 and the mask layer 930 are sequentially stacked on the lower memory channel structure 462, the support structure 464, the second and third sacrificial layer structures 550 and 555 and the fourth insulating interlayer 350.

When the processes illustrated with reference to FIG. 37 are performed, a portion of the third etch stop layer 910 not covered by the upper charge storage structure 406 may be removed to enlarge the preliminary upper channel hole 362 in the vertical direction, and thus the upper channel hole 364 exposing the upper surface of the lower memory channel structure 462 may be formed. The upper channel 416, the upper filling pattern 446 and the upper capping pattern 456 may be formed in the upper channel hole 364.

Accordingly, unlike the upper channel 416 shown in FIGS. 1 to 6, the upper channel 416 of FIG. 4B may not include the lower portion extending through the sixth insulating interlayer 900.

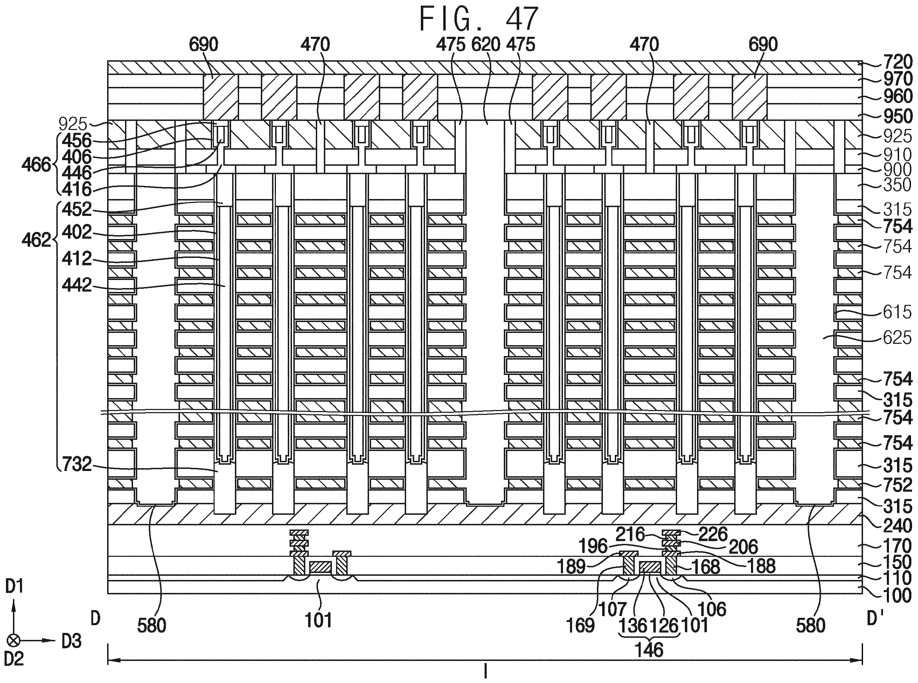

FIG. 47 is across-sectional views illustrating a semiconductor device in accordance with example embodiments, which may correspond to FIG. 5.

This semiconductor device may be substantially the same as or similar to that of FIGS. 1 to 6, except for the lower memory channel structure 462, the channel connection pattern 510, the first support layer 300, the first support pattern 305 and the protection layer 580.

Referring to FIG. 47, the lower memory channel structure 462 may further include a first semiconductor pattern 732 on the substrate 100, and the lower charge storage structure 402, the lower channel 412, the lower filling pattern 442 and the lower capping pattern 452 may be formed on the first semiconductor pattern 732.

The first semiconductor pattern 732 may include or may be formed of, e.g., single crystalline silicon or polysilicon. In an example embodiment, an upper surface of the first semiconductor pattern 732 may be formed at a height between heights of lower and upper surfaces, respectively, of one of the first insulation patterns 315 between the first and second gate electrodes 752 and 754. The lower charge storage structure 402 may have a cup shape of which a lower central portion on the upper surface of the first semiconductor pattern 732 is opened, and may contact an upper edge surface of the first semiconductor pattern 732. The lower channel 412 may have a cup shape on the first semiconductor pattern 732, and may contact an upper surface of a central portion of the first semiconductor pattern 732. Thus, the lower channel 412 may be electrically connected to the first semiconductor pattern 732.

The support structure 464 may further include a second semiconductor pattern, and the dummy charge storage structure 404, the dummy filling pattern 444 and the dummy capping pattern 454 may be formed on the second semiconductor pattern.

The channel connection pattern 510, the first support layer 300 and the first support pattern 305 may not be formed between the CSP 240 and the first gate electrode 752, and the protection layer 580 may not be formed. In an example embodiment, one of the first insulation patterns 315 between the first and second gate electrodes 752 and 754 may have a thickness greater than those of other ones of the first insulation patterns 315.

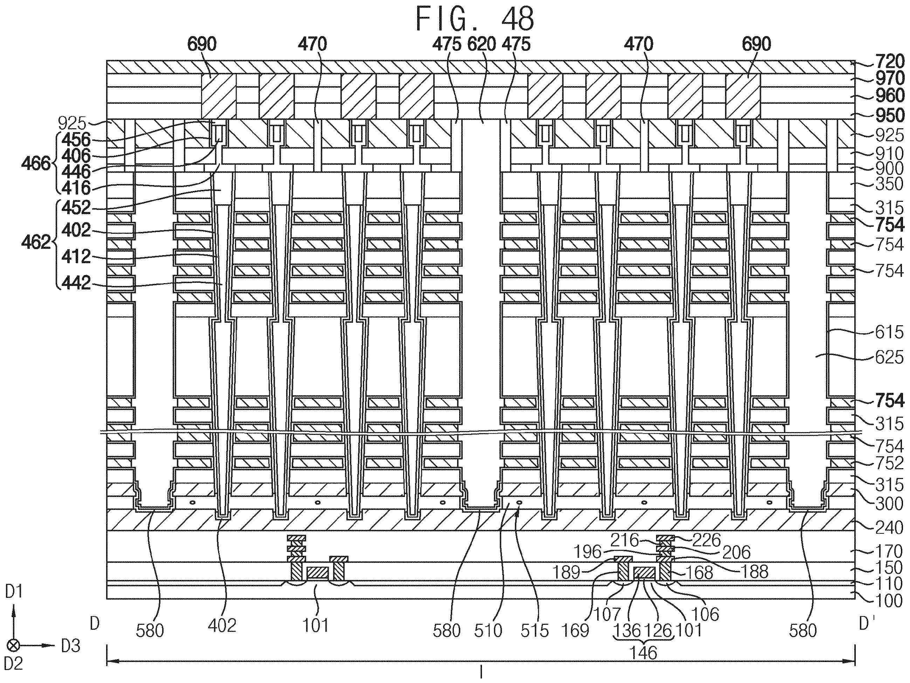

FIG. 48 is a cross-sectional view illustrating a semiconductor device in accordance with example embodiments, which may correspond to FIG. 5. This semiconductor device may be substantially the same as or similar to that of FIGS. 1 to 6, except for the shape of the lower memory channel structure 462.

Referring to FIG. 48, the lower memory channel structure 462 may include lower and upper portions sequentially stacked in the first direction D1, and each of the lower and upper portions may have a width gradually decreasing from a bottom toward a top thereof. In example embodiments, an upper surface of the lower portion of the lower memory channel structure 462 may have a width greater than a lower surface of the upper portion of the lower memory channel structure 462.

FIG. 48 shows that the lower memory channel structure 462 includes two portion stacked in the first direction D1, however, the inventive concept may not be limited thereto, and may include more than two portions stacked in the first direction D 1. Each of the portions of the lower memory channel structure 462 may have a width gradually decreasing from a bottom toward a top thereof, and an upper surface of a portion of the lower memory channel structure 462 may have a width greater than a lower surface of a portion of the lower memory channel structure 462 thereon.

The support structure 464 may have a shape similar to that of the lower memory channel structure 462. That is, the support structure 464 may include a plurality of portions sequentially stacked in the first direction D1, and each of the portions may have a width gradually decreasing from a bottom toward a top thereof.

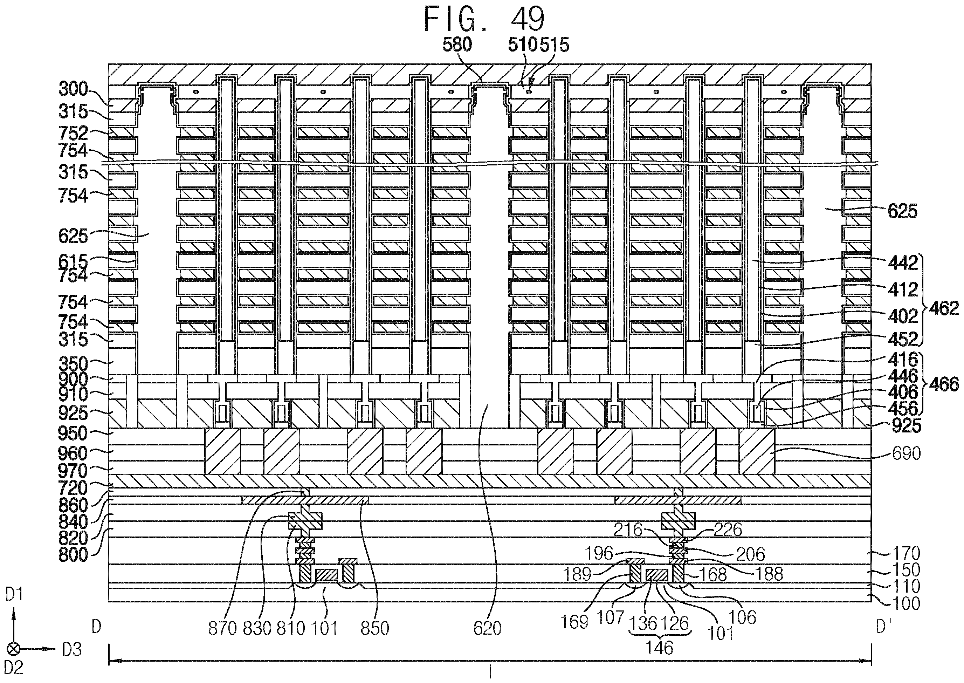

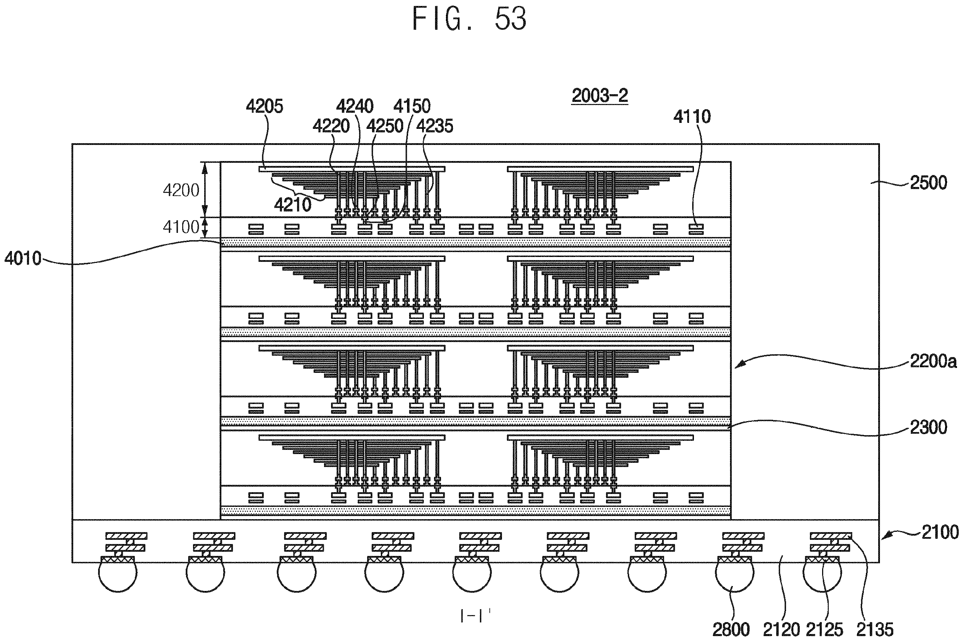

FIG. 49 is a cross-sectional view illustrating a semiconductor device in accordance with example embodiments, which may correspond to FIG. 5. This semiconductor device may be substantially the same as or similar to that of FIGS. 1 to 6, except that the semiconductor device is turned over and bonding structures are further formed. The lower circuit pattern may correspond to a peripheral circuit wiring 4110, and a circuit structure including the lower circuit pattern may correspond to a first structure 4100 in FIG. 53.

Referring to FIG. 49, in example embodiments, twelfth to fifteenth insulating interlayers 800, 820, 840 and 860 may be sequentially stacked on the eighth and ninth lower wirings 222 and 226 and the second insulating interlayer 170. Additionally, a first bonding pattern extending through the twelfth insulating interlayer 800 to contact the eighth lower wiring 222 and a second bonding pattern 810 extending through the twelfth insulating interlayer 800 to contact the ninth lower wiring 226 may be formed, and a third bonding pattern extending through the thirteenth insulating interlayer 820 to contact the first bonding pattern and a fourth bonding pattern 830 extending through the thirteenth insulating interlayer 820 to contact the second bonding pattern 810 may be formed. The first and third bonding patterns and the second and fourth bonding patterns 810 and 830 may include or may be formed of a metal, e.g., copper, aluminum, etc., and may be formed by, e.g., a dual damascene process.

Additionally, a seventh upper wiring extending through the fourteenth insulating interlayer 840 to contact the third bonding pattern and an eighth upper wiring 850 extending through the fourteenth insulating interlayer 840 to contact the fourth bonding pattern may be formed, and a first upper via extending through the fifteenth upper insulating interlayer 860 to contact the seventh upper wiring and a second upper via 870 extending through the fifteenth insulating interlayer 860 to contact the eighth upper wiring 850 may be formed.

At least some of the first to fifth upper wirings 712, 714, 716, 718 and 720 and the sixth upper wiring may be electrically connected to the lower circuit pattern through the first and third bonding patterns and the second and fourth bonding patterns 810 and 830.

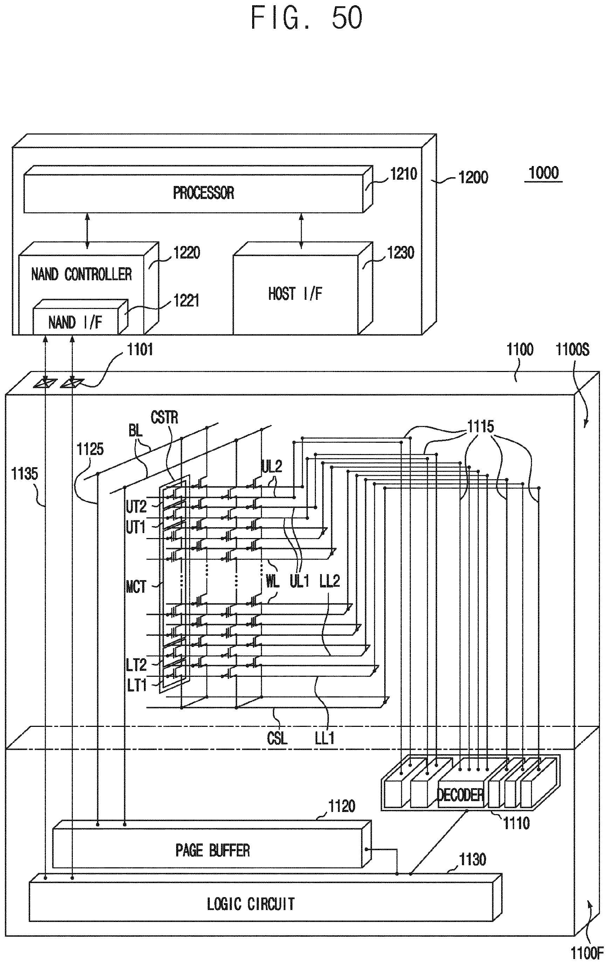

FIG. 50 is a schematic diagram illustrating an electronic system including a semiconductor device in accordance with example embodiments.

Referring to FIG. 50, an electronic system 1000 may include a semiconductor device 1100 and a controller 1200 electrically connected to the semiconductor device 1100. The electronic system 1000 may be a storage device including one or a plurality of semiconductor devices 1100 or an electronic device including a storage device. For example, the electronic system 1000 may be a solid state drive (SSD) device, a universal serial bus (USB), a computing system, a medical device, or a communication device that may include one or a plurality of semiconductor devices 1100.

The semiconductor device 1100 may be a non-volatile memory device, for example, a NAND flash memory device illustrated with reference to FIGS. 1 to 6. The semiconductor device 1100 may include a first structure 1100F and a second structure 1100S on the first structure HOOF. FIG. 50 shows that the first structure 1100F is under the second structure 1100S, however, the first structure 1100F may be formed at a side of or on the second structure 1100S. The first structure 1100F may be a peripheral circuit structure including a decoder circuit 1110, a page buffer 1120, and a logic circuit 1130. The second structure 1100S may be a memory cell structure including a bit line BL, a common source line CSL, word lines WL, first and second upper gate lines UL1 and UL2, first and second lower gate lines LL1 and LL2, and memory cell strings CSTR between the bit line BL and the common source line CSL.

In the second structure 1100S, each of the memory cell strings CSTR may include lower transistors LT1 and LT2 adjacent to the common source line CSL, upper transistors UT1 and UT2 adjacent to the bit line BL, and a plurality of memory cell transistors MCT between the lower transistors LT1 and LT2 and the upper transistors UT1 and UT2. The number of the lower transistors LT1 and LT2 and the number of the upper transistors UT1 and UT2 may be varied in accordance with example embodiments.

In example embodiments, the upper transistors UT1 and UT2 may include string selection transistors, and the lower transistors LT1 and LT2 may include ground selection transistors. The lower gate lines LL1 and LL2 may be gate electrodes of the lower transistors LT1 and LT2, respectively. The word lines WL may be gate electrodes of the memory cell transistors MCT, respectively, and the upper gate lines UL1 and UL2 may be gate electrodes of the upper transistors UT1 and UT2, respectively.

In example embodiments, the lower transistors LT1 and LT2 may include a lower erase control transistor LT1 and a ground selection transistor LT2 that may be connected with each other in serial. The upper transistors UT1 and UT2 may include a string selection transistor UT1 and an upper erase control transistor UT2. At least one of the lower erase control transistor LT1 and the upper erase control transistor UT2 may be used in an erase operation for erasing data stored in the memory cell transistors MCT through gate induced drain leakage (GIDL) phenomenon.

The common source line CSL, the first and second lower gate lines LL1 and LL2, the word lines WL, and the first and second upper gate lines UL1 and UL2 may be electrically connected to the decoder circuit 1110 through first connection wirings 1115 extending to the second structure 1110S in the first structure HOOF. The bit lines BL may be electrically connected to the page buffer 1120 through second connection wirings 1125 extending to the second structure 1100S in the first structure 1100F.

In the first structure 1100F, the decoder circuit 1110 and the page buffer 1120 may perform a control operation for at least one selected memory cell transistor among the plurality of memory cell transistors MCT. The decoder circuit 1110 and the page buffer 1120 may be controlled by the logic circuit 1130. The semiconductor device 1100 may communicate with the controller 1200 through an input/output pad 1101 electrically connected to the logic circuit 1130. The input/output pad 1101 may be electrically connected to the logic circuit 1130 through an input/output connection wiring 1135 extending to the second structure 1100S in the first structure 1100F.

The controller 1200 may include a processor 1210, a NAND controller 1220, and a host interface 1230. The electronic system 1000 may include a plurality of semiconductor devices 1100, and in this case, the controller 1200 may control the plurality of semiconductor devices 1100.

The processor 1210 may control operations of the electronic system 1000 including the controller 1200. The processor 1210 may be operated by firmware, and may control the NAND controller 1220 to access the semiconductor device 1100. The NAND controller 1220 may include a NAND interface 1221 for communicating with the semiconductor device 1100. Through the NAND interface 1221, control command for controlling the semiconductor device 1100, data to be written in the memory cell transistors MCT of the semiconductor device 1100, data to be read from the memory cell transistors MCT of the semiconductor device 1100, etc., may be transferred. The host interface 1230 may provide communication between the electronic system 1000 and an outside host. When control command is received from the outside host through the host interface 1230, the processor 1210 may control the semiconductor device 1100 in response to the control command.

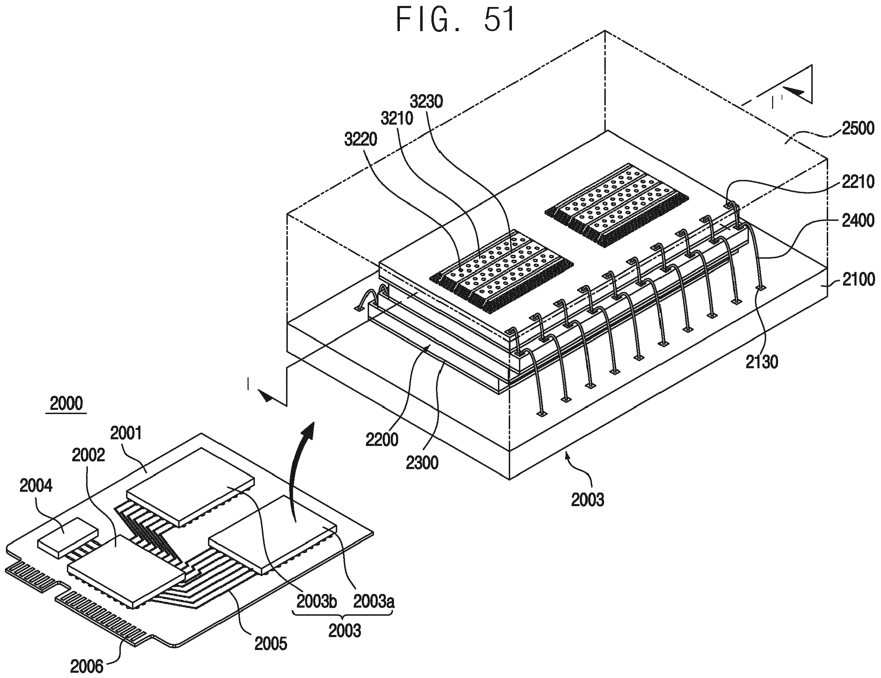

FIG. 51 is a schematic perspective view illustrating an electronic system including a semiconductor device in accordance with example embodiments.

Referring to FIG. 51, an electronic system 2000 may include a main substrate 2001, a controller 2002 mounted on the main substrate 2001, at least one semiconductor package 2003, and a dynamic random access memory (DRAM) device 2004. The semiconductor package 2003 and the DRAM device 2004 may be connected to the controller 2002 by wiring patterns 2005 on the main substrate 2001.

The main substrate 2001 may include a connector 2006 having a plurality of pins connected to an outside host. The number and layout of the plurality pins in the connector 2006 may be changed depending on communication interface between the electronic system 2000 and the outside host. In example embodiments, the electronic system 2000 may communicate with the outside host according to one of a USB, peripheral component interconnect express (PCI-Express), serial advanced technology attachment (SATA), M-Phy for universal flash storage (UFS), etc. In example embodiments, the electronic system 2000 may be operated by power source provided from the outside host through the connector 2006. The electronic system 2000 may further include power management integrated circuit (PMIC) for distributing the power source provided from the outside host to the controller 2002 and the semiconductor package 2003.

The controller 2002 may write data in the semiconductor package 2003 or read data from the semiconductor package 2003, and may enhance the operation speed of the electronic system 2000.

The DRAM device 2004 may be a buffer memory for reducing the speed difference between the semiconductor package 2003 for storing data and the outside host. The DRAM device 2004 included in the electronic system 2000 may serve as a cache memory, and may provide a space for temporarily storing data during the control operation for the semiconductor package 2003. If the electronic system 2000 includes the DRAM device 2004, the controller 2002 may further include a DRAM controller for controlling the DRAM device 2004 in addition to the NAND controller for controlling the semiconductor package 2003.

The semiconductor package 2003 may include first and second semiconductor packages 2003a and 2003b spaced apart from each other. The first and second semiconductor packages 2003a and 2003b may be semiconductor packages each of which may include a plurality of semiconductor chips 2200. Each of the first and second semiconductor packages 2003a and 2003b may include a package substrate 2100, the semiconductor chips 2200, bonding layers 2300 disposed under the semiconductor chips 2200, a connection structure 2400 for electrically connecting the semiconductor chips 2200 and the package substrate 2100, and a mold layer 2500 covering the semiconductor chips 2200 and the connection structure 2400 on the package substrate 2100.

The package substrate 2100 may be a printed circuit board (PCB) including package upper pads 2130. Each semiconductor chip 2200 may include an input/output pad 2210. The input/output pad 2210 may correspond to the input/output pad 1101 of FIG. 50. Each semiconductor chip 2200 may include gate electrode structures 3210, memory channel structures 3220 extending through the gate electrode structures 3210, and division structures 3230 for dividing the gate electrode structures 3210. Each semiconductor chip 2200 may include a semiconductor device illustrated with reference to FIGS. 1 to 6.

In example embodiments, the connection structure 2400 may be a bonding wire for electrically connecting the input/output pad 2210 and the package upper pads 2130. Thus, in each of the first and second semiconductor packages 2003a and 2003b, the semiconductor chips 2200 may be electrically connected with each other by a bonding wire method, and may be electrically connected to the package upper pads 2130 of the package substrate 2100. Alternatively, in each of the first and second semiconductor packages 2003a and 2003b, the semiconductor chips 2200 may be electrically connected with each other by a connection structure including a through silicon via (TSV), instead of the connection structure 2400 of the bonding wire method.

In example embodiments, the controller 2002 and the semiconductor chips 2200 may be included in one package. In example embodiments, the controller 2002 and the semiconductor chips 2200 may be mounted on an interposer substrate different from the main substrate 2001, and the controller 2002 and the semiconductor chips 2200 may be connected with each other by a wiring on the interposer substrate.

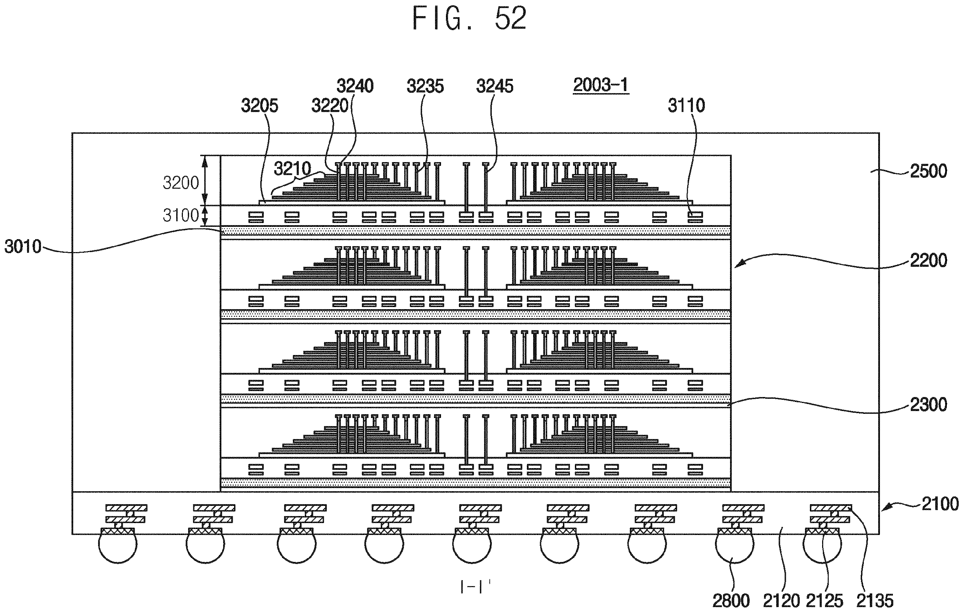

FIGS. 52 and 53 are schematic cross-sectional views illustrating a semiconductor package that may include a semiconductor device in accordance with example embodiments. FIGS. 52 and 53 illustrate example embodiments of the semiconductor package 2003 shown in FIG. 51, and show a cross-section taken along a line I-I' of the semiconductor package 2003 in FIG. 51.

Referring to FIG. 52, in the semiconductor package 2003, the package substrate 2100 may be a PCB. The package substrate 2100 may include a substrate body part 2120, upper pads 2130 (refer to FIG. 51) on an upper surface of the substrate body part 2120, lower pads 2125 on a lower surface of the substrate body part 2120 or exposed through the lower surface of the substrate body part 2120, and inner wirings 2135 for electrically connecting the upper pads 2130 and the lower pads 2125 in an inside of the substrate body part 2120. The upper pads 2130 may be electrically connected to the connection structures 2400. The lower pads 2125 may be connected to wiring patterns 2005 of the main substrate 2010 in the electronic system 2000 through conductive connection parts 2800, as shown in FIG. 45.

Each semiconductor chip 2200 may include a semiconductor substrate 3010, and a first structure 3100 and a second structure 3200 sequentially stacked on the semiconductor substrate 3010. The first structure 3100 may include a peripheral circuit region in which peripheral circuit wirings 3110 may be formed. The second structure 3200 may include a common source line 3205, a gate electrode structure 3210 on the common source line 3205, memory channel structures 3220 and division structures 3230 (refer to FIG. 51) extending through the gate electrode structure 3210, bit lines 3240 electrically connected to the memory channel structures 3220, and gate connection wirings 3235 electrically connected to the word lines WL of the gate electrode structure 3210 (refer to FIG. 50).

Each semiconductor chip 2200 may include a through wiring 3245 being electrically connected to the peripheral circuit wirings 3110 of the first structure 3100 and extending in the second structure 3200. The through wiring 3245 may be disposed at an outside of the gate electrode structure 3210, and the through wirings 3245 may extend through the gate electrode structure 3210. Each semiconductor chip 2200 may further include the input/output pad 2210 (refer to FIG. 51) electrically connected to the peripheral circuit wirings 3110 of the first structure 3100.

Referring to FIG. 53, in a semiconductor package 2003A, each semiconductor chip 2200a may include a semiconductor substrate 4010, a first structure 4100 on the semiconductor substrate 4010, and a second structure 4200 on and bonded with the first structure 4100 by a wafer bonding method.

The first structure 4100 may include a peripheral circuit region in which a peripheral circuit wiring 4110 and first bonding structures 4150 may be formed. The second structure 4200 may include a common source line 4205, a gate electrode structure 4210 between the common source line 4205 and the first structure 4100, memory channel structures 4220 and the division structure 3230 (refer to FIG. 51) extending through the gate electrode structure 4210, and second bonding structures 4250 electrically connected to the memory channel structures 4220 and the word lines WL (refer to FIG. 50) of the gate electrode structure 4210. For example, the second bonding structures 4250 may be electrically connected to the memory channel structures 4220 and the word lines WL (refer to FIG. 50) through the bit lines 4240 electrically connected to the memory channel structures 4220 and the gate connection wirings 4235 electrically connected to the word lines WL (refer to FIG. 50), respectively. The first bonding structures 4150 of the first structure 4100 and the second bonding structures 4250 of the second structure 4200 may contact each other to be bonded with each other. The first bonding structures 4150 and the second bonding structures 4250 may include or may be formed of, for example, copper.

Each semiconductor chip 2200a may further include the input/output pad 2210 (refer to FIG. 51) electrically connected to the peripheral circuit wirings 4110 of the first structure 4100.

The semiconductor chips 2200 of FIG. 52 and the semiconductor chips 2200a of FIG. 53 may be electrically connected with each other by the connection structures 2400 in a bonding wire method. However, in example embodiments, semiconductor chips such as the semiconductor chips 2200 of FIG. 52 and the semiconductor chips 2200a of FIG. 53 in the same semiconductor package may be electrically connected with each other by a connection structure including a TSV

While example embodiments have been particularly shown and described, it will be understood by one of ordinary skill in the art that variations in form and detail may be made therein without departing from the spirit and scope of the claims.

## Claims

1. A semiconductor device comprising:
a gate electrode structure including a plurality of gate electrodes spaced apart from each other on a substrate in a first direction substantially perpendicular to an upper surface of the substrate, each of the plurality of gate electrodes extending in a second direction substantially parallel to the upper surface of the substrate;
a memory channel structure extending through the gate electrode structure;
a plurality of first division patterns spaced apart from each other in a third direction substantially parallel to the upper surface of the substrate and crossing the second direction,
wherein the gate electrode structure is interposed between two adjacent first division patterns among the plurality of first division patterns, and
wherein each of the plurality of first division patterns extends in the second direction; and
a plurality of first support patterns spaced apart from each other in the second direction,
wherein the plurality of first support patterns are arranged along a first straight line extending in the second direction,
wherein a corresponding first division pattern of the plurality of first division patterns extends along the first straight line such that the corresponding first division pattern and the plurality of first support patterns are arranged along the first straight line, and
wherein each of the plurality of first support patterns includes a conductive material.

2. The semiconductor device of claim 1,
wherein the conductive material of each of the first support patterns is doped polysilicon.

3. The semiconductor device of claim 1, further comprising:
a pair of second division patterns extending in the second direction and spaced apart from each other in the third direction,
wherein the pair of second division patterns contact opposite sidewalls of each of the plurality of first support patterns.

4. The semiconductor device of claim 1,
wherein the plurality of gate electrodes in the gate electrode structure include a first gate electrode, at least one second gate electrode, and a third gate electrode that are sequentially stacked in the first direction,
wherein the first gate electrode is a lowermost gate electrode of the gate electrodes, the third gate electrode is an uppermost gate electrode of the gate electrodes, and the at least one second gate electrode is interposed between the first gate electrode and the third gate electrode, and
wherein each of the plurality of first support patterns is disposed at a level substantially the same as a level of the third gate electrode.

5. The semiconductor device of claim 4,
wherein each of the plurality of first support patterns includes a material that is substantially the same as a material of the third gate electrode.

6. The semiconductor device of claim 4,
wherein the memory channel structure includes a lower memory channel structure extending through the first and second gate electrodes and an upper memory channel structure extending through the third gate electrode.

7. The semiconductor device of claim 4, further comprising:
a third division pattern extending through the third gate electrode in the second direction.

8. The semiconductor device of claim 4, further comprising:
a fourth division pattern partially extending in the second direction,
wherein the fourth division pattern extends through the first gate electrode and the at least one second gate electrode between the two adjacent first division patterns without extending through the third gate electrode therebetween.

9. The semiconductor device of claim 8, further comprising:
a plurality of second support patterns spaced apart from each other in the second direction,
wherein the fourth division pattern and the plurality of second support patterns are arranged along a second straight line extending in the second direction, the second straight line being spaced apart from the first straight line in the third direction, and
wherein each of the plurality of second support patterns includes a conductive material.

10. The semiconductor device of claim 9,
wherein the plurality of first and second support patterns are arranged in a zigzag pattern in the second direction.

11. A semiconductor device comprising:
a gate electrode structure including a plurality of gate electrodes spaced apart from each other on a substrate in a first direction substantially perpendicular to an upper surface of the substrate, each of the plurality of gate electrodes extending in a second direction substantially parallel to the upper surface of the substrate;
a memory channel structure extending through the gate electrode structure on the substrate;
a plurality of first division patterns spaced apart from each other in a third direction substantially parallel to the upper surface of the substrate and crossing the second direction,
wherein the gate electrode structure is interposed between two adjacent first division patterns among the plurality of first division patterns, and
wherein each of the plurality of first division patterns extends in the second direction; and
a plurality of first support patterns spaced apart from each other in the second direction,
wherein the plurality of first support patterns are arranged along a first straight line extending in the second direction,
wherein a corresponding first division pattern of the plurality of first division patterns extends along the first straight line,
wherein the plurality of gate electrodes of the gate electrode structure includes a first gate electrode, at least one second gate electrode, and a third gate electrode that are sequentially stacked in the first direction,
wherein the first gate electrode is a lowermost gate electrode of the gate electrodes, the third gate electrode is an uppermost gate electrode of the gate electrodes, and the at least one second gate electrode is interposed between the first gate electrode and the third gate electrode, and
wherein each of the plurality of first support patterns is disposed at a level substantially the same as a level of the third gate electrode.

12. The semiconductor device of claim 11,
wherein the third gate electrode and each of the plurality of first support patterns include doped polysilicon.

13. The semiconductor device of claim 11,
wherein the third gate electrode serves as a string selection line (SSL).

14. The semiconductor device of claim 11, further comprising:
a pair of second division patterns extending in the second direction and spaced apart from each other in the third direction,
wherein the pair of second division patterns contact opposite sidewalls of each of the plurality of first support patterns.

15. The semiconductor device of claim 11, further comprising:
a third division pattern extending through the third gate electrode in the second direction.
